# FASCICULE DE BREVET EUROPEEN

(11) **EP 3 766 829 B1**
(45) Date de publication et mention de la délivrance du brevet: **29.11.2023**
(21) Numéro de dépôt: 20185346.2
(22) Date de dépôt: 10.07.2020
(51) Int. Cl.: B81B 3/00, B81B 5/00

(54) **LIAISON MECANIQUE POUR DISPOSITIF MEMS ET NEMS DE MESURE D'UNE VARIATION DE PRESSION ET DISPOSITIF COMPRENANT UNE TELLE LIAISON MECANIQUE**
MECHANISCHE VERBINDUNG FÜR MEMS- UND NEMS-VORRICHTUNGEN ZUM MESSEN EINER DRUCKVERÄNDERUNG UND VORRICHTUNG, DIE EINE SOLCHE MECHANISCHE VERBINDUNG UMFASST
MECHANICAL LINK FOR MEMS AND NEMS DEVICE FOR MEASURING A PRESSURE VARIATION AND DEVICE COMPRISING SUCH A MECHANICAL LINK

(30) Priorité: 18.07.2019 FR 1908128
(43) Date de publication de la demande: 20.01.2021
(73) Titulaire: Commissariat à l'Energie Atomique et aux Energies Alternatives, 75015 Paris (FR)
(72) Inventeur: JOET, Loïc, 38054 GRENOBLE Cedex 09 (FR)
(74) Mandataire: Atout PI Laplace

(56) Documents cités:
- FR-A1- 2 977 319
- FR-A1- 3 059 659
- US-A- 5 317 917

## Description

### Domaine technique de l'invention

La présente invention se situe dans le domaine des microphones et plus généralement des dispositifs de mesure d'une variation de pression utilisant les technologies « MEMS » (MicroElectroMechanical Systems) et/ou « NEMS » (NanoElectroMechanical Systems). Les dispositifs utilisant les deux technologies seront désignés dans l'ensemble de la description par « dispositifs MEMS-NEMS ».

Plus précisément, l'invention concerne une liaison mécanique pour un dispositif MEMS-NEMS de mesure d'une variation de pression qui utilise la détection d'un mouvement (déplacement ou déformation) d'une pièce mobile telle une membrane ou un piston par rapport à une pièce fixe telle un substrat, ledit mouvement étant transmis à un détecteur de mouvement notamment capacitif qui permet de le mesurer.

Un dispositif MEMS-NEMS de mesure d'une variation de pression peut être un microphone, un capteur de pression absolu ou différentiel.

### Etat de la technique

Les microphones MEMS et/ou NEMS représentent un marché en pleine expansion, notamment grâce au marché des appareils nomades, tels que les tablettes, les téléphones portables type smartphone et autres objets connectés, dans lesquels ils remplacent peu à peu les microphones à électret.

Les microphones mesurent une variation de pression, ils comportent donc au moins une partie en contact avec l'extérieur.

La plupart des microphones MEMS actuellement produits sont des microphones à détection capacitive, dont un exemple de réalisation est décrit dans le document US20050179100.

Un microphone à détection capacitive connu comprend une membrane souple séparant l'extérieur d'une chambre au moins partiellement fermée, dite volume arrière, servant de référence de pression. La membrane se déforme sous l'effet du différentiel de pression entre ses deux surfaces. La membrane forme une électrode. Une contre-électrode fixe et rigide est disposée en regard de la membrane. La membrane et la contre électrode forment une capacité dont la valeur varie en fonction de la déformation de la membrane sous l'effet du différentiel de pression entre ses deux surfaces. Des trous dans la membrane, dit trous de ventilation, assurent l'égalisation des pressions entre l'extérieur et le volume arrière du microphone. Cela permet notamment de filtrer les phénomènes basses fréquences (par exemple dus à l'altitude, à une dépression ...) qui peuvent être sont beaucoup plus importants que le son à mesurer, et ce, sans atténuer les signaux supérieurs à quelques dizaines ou centaines de Hertz. La contre-électrode est également percée de trous et laisse passer l'air afin que la pression puisse s'établir sur la surface de la membrane.

Cette structure offre un certain nombre d'avantages, cependant elle présente des inconvénients notamment dus à la présence de la contre-électrode. En effet, celle-ci se trouve dans le chemin acoustique. Bien que trouée, elle présente une résistance acoustique, i.e. elle offre une résistance au passage de l'air, et donc à l'établissement de la pression. Ainsi, lorsque les trous sont trop petits et/ou trop éloignés, la résistance acoustique se manifeste par un bruit (induit par la contre électrode) qui dégrade la qualité du signal avant toute transduction. Pour limiter cette résistance, la densité ainsi que la taille des trous peuvent être augmentées, mais ceci a pour conséquence directe la réduction des surfaces en regard, ce qui réduit proportionnellement la détection capacitive. Ainsi, le signal électrique est donc plus faible et le bruit électronique (notamment induit par le traitement du signal) est moins masqué. Dans les deux cas, cela entraine une dégradation du seuil de détection. Pour une taille de membrane fixée, il faut trouver un design qui permette de minimiser la dégradation globale du seuil de détection.

La contre électrode étant la principale cause de pertes de performances, une solution est de réduire son impact, voire de la supprimer.

Il existe des microphones MEMS à détection piézoélectrique qui permettent notamment de supprimer les inconvénients résultant de la contre-électrode. Par exemple, la membrane comporte un matériau piézoélectrique. Lors de sa déformation, des charges sont créées à la surface du matériau piézoélectrique et sont collectées par des électrodes encapsulant ce matériau. Le signal électrique, i.e. le nombre de charges créées, est représentatif de la déformation de la membrane. Cependant, dans le cas de la détection piézoélectrique, le nombre de charges est donné par les contraintes mécaniques au coeur du matériau, il ne peut pas être augmenté grâce à une tension de polarisation ou tout autre artéfact externe. Si l'on souhaite obtenir plus de charges, il faut augmenter la taille de la membrane pour récolter plus d'énergie, afin de contraindre plus le matériau piézoélectrique.

Or, comme pour la détection capacitive, on souhaite éviter une augmentation de surface de membrane. En effet, outre que cela a pour conséquence d'augmenter la taille de la structure et donc son coût, une membrane de plus grande surface va déplacer plus d'air en se déformant. Ce volume d'air déplacé crée une variation de la pression dans la cavité arrière, imposant alors une force opposée au mouvement sur la membrane. Cette force est proportionnelle au ratio du carré de la surface de membrane, sur le volume arrière. Cette force agit comme un ressort supplémentaire sur la membrane, ressort qui va s'opposer au déplacement. L'augmentation de la surface de la membrane devra donc être accompagnée par une augmentation de la taille du volume arrière, et donc du boîtier si l'on veut maintenir un déplacement équivalent de la membrane.

Par conséquent, un microphone à détection piézoélectrique offre un gain limité par rapport à celui de la détection capacitive.

D'autres solutions consistent à retirer la contre électrode du chemin acoustique. Ainsi une première solution consiste à séparer la transduction mécanique (membrane) et la transduction électrique (électrodes) en déportant cette dernière, la contre-électrode se retrouve de fait en dehors du chemin acoustique. Une seconde solution qui peut être complémentaire de la première consiste à réaliser la transduction électrique sous vide, comme pour le microphone MEMS-NEMS décrit dans la demande de brevet FR3059659. La transduction électrique étant dans le vide, elle ne provoque plus aucun bruit acoustique.

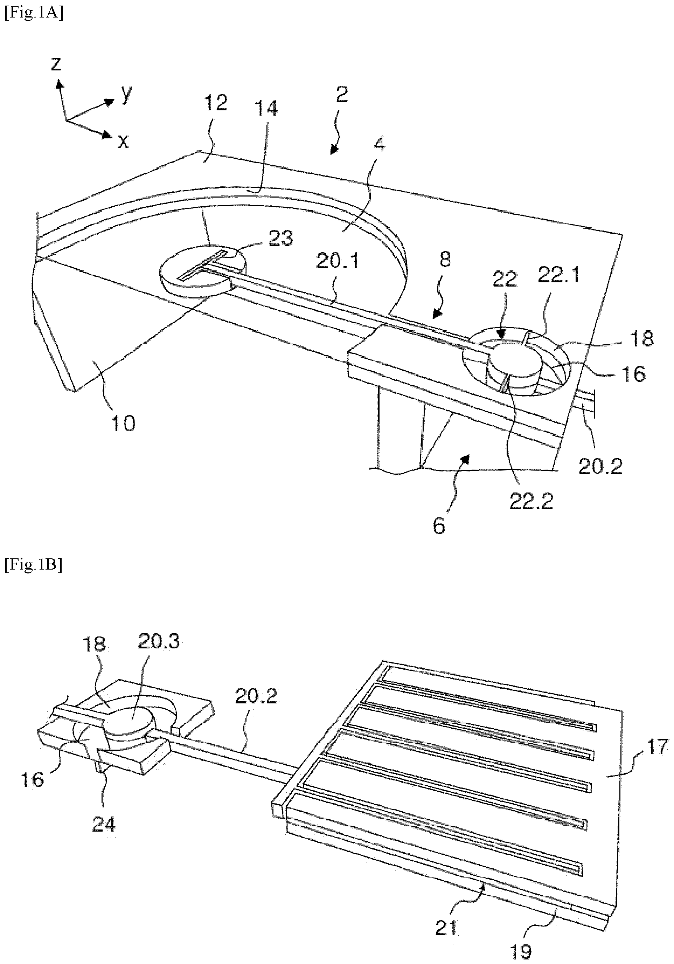

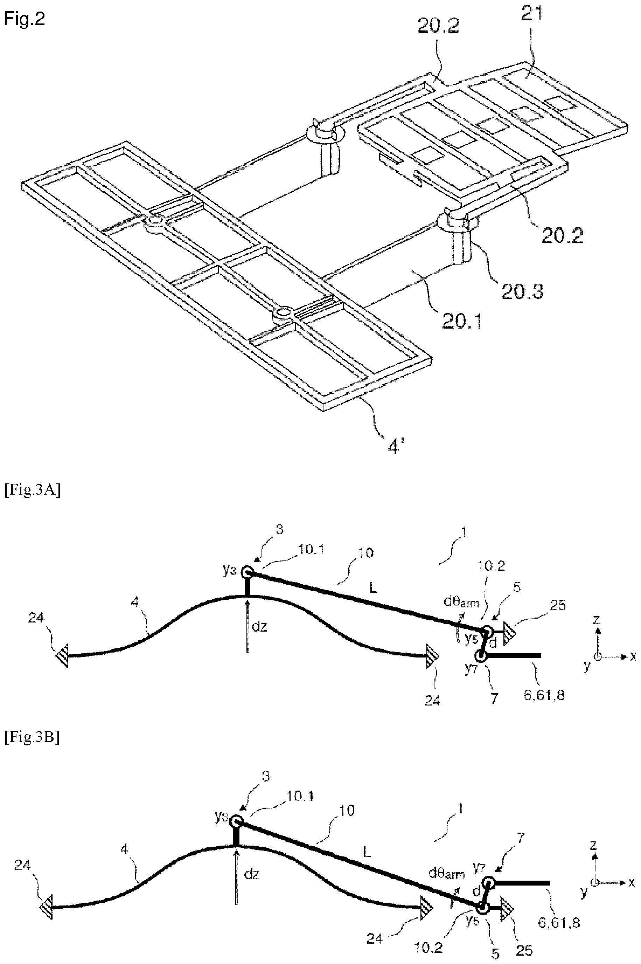

Cette seconde solution est illustrée en figures 1A (vue de dessus), 1B (vue de dessous) et une variante est illustrée en figure 2.

Le dispositif représenté comprend un boîtier 2, une membrane de mesure 4 en contact avec l'environnement extérieur (généralement l'air) dont on veut mesurer une variation de pression, une chambre de mesure 6 isolée de l'environnement extérieur (et apte à être mise sous vide) et un élément de transmission mécanique 20 (formé par les éléments 20.1, 20.2 et 20.3 sur les figures 1A et 1B, comme explicité plus après) entre l'environnement extérieur et la chambre de mesure 6. La membrane de mesure 4 est réalisée dans une couche mince (NEMS) par exemple de l'ordre de 1µm. Le boîtier 2 comporte une plaque supérieure 12 qui comprend une première ouverture 14 partiellement fermée par la membrane de mesure 4 et une deuxième ouverture 18 débouchant dans la chambre de mesure 6 et obturée en partie par une membrane d'étanchéité 16. L'élément de transmission 20 comporte un premier bras de transmission 20.1 disposé dans l'environnement extérieur, un deuxième bras de transmission 20.2 disposé dans la chambre de mesure 6 et un arbre de transmission 20.3 (charnière) reliant rigidement les deux bras tout en assurant l'étanchéité de ladite chambre de mesure. L'élément de transmission 20 s'étend au repos le long de la direction X. Il est articulé en rotation par une articulation pivot 22 sur le boîtier 2. L'articulation pivot 22 comporte deux lames 22.1 et 22.2 reliées au boîtier 2 et à la charnière 20.3 et présentant une dimension faible dans la direction X de sorte à être déformable en torsion autour de la direction Y et définir ainsi avec la membrane d'étanchéité 16 l'axe de rotation de l'articulation pivot 22. L'élément de transmission 20 est rigide ou peu déformable. L'extrémité libre du premier bras de transmission 20.1 est reliée à la membrane 4 par une articulation 23 (formée par au moins une lame de torsion) transmettant le déplacement le long de la direction Z tout en autorisant la rotation autour de l'axe Y et la translation le long de l'axe X, par exemple deux lames parallèles à l'axe Y et déformables en torsion. L'extrémité libre du deuxième bras de transmission 20.2 est reliée à une électrode mobile 21 qui fait partie des moyens de mesure capacitive. L'électrode mobile 21 est disposée dans la chambre de mesure sous vide. Dans cette configuration, le mouvement du deuxième bras de transmission 20.2 relié à l'électrode mobile est hors plan. La mesure capacitive est obtenue grâce au mouvement de l'électrode mobile 21, se déplaçant hors plan, et réalisant une variation d'entrefer avec au moins une électrode fixe 17 placée en regard de manière à permettre une détection capacitive.

La figure 1B (vue de dessous) illustre le cas où les moyens de mesure capacitive (transduction capacitive) comportent une première électrode fixe 17, une deuxième électrode fixe 19 à distance de la première électrode fixe 17 et une électrode mobile 21 fixée sur l'extrémité libre du deuxième bras de transmission 20.2, qui se déplace ainsi avec le bras de transmission. L'électrode mobile 21 est disposée entre la première électrode fixe 17 et la deuxième électrode fixe 19 parallèlement à celles-ci et apte à se rapprocher de l'une ou de l'autre. De tels moyens de mesure permettent une mesure différentielle. En mesurant la variation d'entrefer entre l'électrode mobile 21 et la première électrode fixe 17 et entre l'électrode mobile 21 et la deuxième électrode fixe 19, on peut détecter le déplacement de l'élément de transmission 20, induit par le déplacement de la membrane de mesure 4 et ainsi déterminer la variation de pression. Une électrode fixe peut être désignée « contre-électrode ».

Selon une variante, la membrane peut être remplacée par un piston 4' qui peut être détouré et/ou rigidifié par un ou des renforts par exemple des poutres de renfort (ou poutres de rigidification), comme illustré en figure 2.

Le deuxième bras de transmission 20.2 peut être désigné « bras de levier ».

Un premier problème lié à cette configuration est la déformation de l'électrode mobile sous l'effet des forces électrostatiques, ce qui limite la longueur du bras de levier. Ce problème est amplifié lorsque le substrat n'est pas conducteur et qu'une seule contre électrode est utilisée, puisque les forces électrostatiques ne peuvent pas dans ce cas s'équilibrer entre elles localement (on peut les équilibrer en créant une balance de Roberval, mais pas les annuler localement). Pour réduire ces déformations, une solution est d'augmenter l'épaisseur de la couche MEMS pour augmenter la raideur en flexion hors plan du bras de levier et/ou ajouter des poutres de rigidification sur l'électrode mobile. Cependant l'épaisseur de la couche MEMS est limitée à 10-30 µm par épitaxie, et aller au-delà rendrait le procédé trop coûteux. En outre, si l'épaisseur était augmentée, la gravure profonde imposerait des larges tranchées pour respecter un rapport largeur/profondeur d'aspect raisonnable, ce qui pourrait induire des fuites trop importantes autour de la membrane ou du piston.

Un second problème vient de l'épaisseur de la couche mince (NEMS) de la membrane ou du piston. L'épaisseur recherchée est de l'ordre de 1 µm afin que la membrane ou le piston assure une étanchéité tout en restant souple. Cependant, la couche mince qui forme aussi l'électrode mobile se déforme sous l'effet des forces électrostatiques et une rigidification de l'électrode mobile par la couche épaisse est nécessaire pour éviter cette déformation. Comme indiqué ci-dessus, la rigidification est généralement réalisée par un réseau de poutres de rigidification disposées régulièrement par rapport à la surface totale de l'électrode mobile. D'autre part, pour polariser chacune des contre-électrodes délimitées par ce réseau, il est nécessaire de réaliser des plots de polarisation, ce qui occupe une place non négligeable. Les poutres de rigidification et les plots de polarisation laissent peu de place pour l'électrode mobile. Si on diminue le nombre de poutres de rigidification et donc le nombre de plots de contre-électrodes, on retrouve le premier problème de déformation de l'électrode mobile sous l'effet des forces électrostatiques.

Un troisième problème vient de ce que l'entrefer de la détection capacitive est défini et donc limité par les épaisseurs des deux couches sacrificielles (oxyde) qui permettent de libérer l'électrode mobile par rapport à la contre électrode (ou aux contres électrodes). Comme pour les problèmes précédents, le fait que ces épaisseurs soient les mêmes sur toute la structure impose des compromis. Pour les contraintes liées à l'électrode mobile, on cherche des entrefers de l'ordre de 1 µm qui permet une forte densité avec une bonne linéarité. Pour les contraintes liées à la membrane (ou au piston), on cherche un entrefer le plus grand possible pour limiter les effets de pincement de la couche d'air entre les bords de la membrane (ou du piston) et les bords de la première ouverture au-dessus duquel elle se trouve. Cette même épaisseur se répercute sur toute la structure, et notamment à l'extérieur de la chambre de mesure (côté air). En particulier tout autour de la membrane ou du piston, sur une dizaine de microns, la membrane ou le piston déborde de la première ouverture 14. Quand la membrane (ou le piston) se déplace, elle (ou il) pince le film d'air entre elle (lui) et la partie fixe au niveau de ce débord, ce qui crée de l'amortissement. Pour limiter cet effet d'amortissement, il faudrait que l'épaisseur de la membrane ou du piston soit la plus grande possible. Or, on sait que l'épaisseur recherchée est de l'ordre de 1 µm afin que la membrane ou le piston assure une étanchéité tout en restant souple.

En conclusion, cette configuration nécessite de limiter la longueur du bras de levier donc de limiter l'amplification du mouvement de la membrane ou du piston pour éviter d'induire un risque de déformation de l'électrode mobile et/ou du bras de levier. Or limiter la longueur du bras de levier limite aussi la taille de la détection capacitive dans le sens du bras, d'autant que la densité capacitive peut être déjà réduite si on ajoute des poutres de rigidification et des plots de polarisation. En outre, cette configuration impose une limitation de l'entrefer et par conséquent de la densité capacitive.

Le document US5317917 décrit un capteur de pression résonant comportant une membrane déformable, soumise à l'ambiance où règne la pression à mesurer, un convertisseur, apte à transmettre la force ainsi supportée par cette membrane à un résonateur mis en vibration par un excitateur et dont la fréquence de résonance que l'on mesure est fonction de l'intensité de cette force, donc de la pression à déterminer.

L'invention vise à surmonter les inconvénients précités de l'art antérieur.

En particulier elle vise à disposer d'un dispositif MEMS et/ou NEMS de mesure d'une variation de pression, par exemple un microphone MEMS et/ou NEMS à détection capacitive, qui permette d'éviter les inconvénients dus à la présence d'une contre-électrode, tout en évitant une déformation de l'électrode mobile (ou des électrodes mobiles) et de la structure du dispositif, et ce, en ne réduisant pas la capacité de détection capacitive, voire en augmentant la capacité de détection capacitive.

Plus largement, l'invention vise à disposer d'une structure MEMS-NEMS conçue pour un dispositif de mesure d'une variation de pression comprenant une pièce mobile se déformant ou se déplaçant sous l'effet d'une variation de pression, la déformation ou le déplacement étant mesuré(e) par des moyens de détection, et qui surmonte les inconvénients mentionnés.

### Expose de l'invention

Une solution permettant de remédier à ces inconvénients concerne une liaison mécanique et un dispositif de mesure d'une variation de pression comprenant au moins une telle liaison mécanique.

Un premier objet de l'invention concerne une liaison mécanique pour un dispositif microélectromécanique et/ou nanoélectromécanique de mesure d'une variation de pression, ledit dispositif comprenant une pièce fixe s'étendant selon un plan principal, une pièce mobile apte à se déplacer ou à se déformer selon une direction hors-plan sous l'effet d'une variation de pression, et des moyens de détection dudit déplacement ou de ladite déformation comprenant au moins un élément mobile, la liaison mécanique comprenant :
- un bras de levier ;
- une première liaison reliant la pièce mobile à une première extrémité du bras de levier, ladite première liaison étant adaptée pour transmettre le déplacement hors plan de ladite pièce mobile à ladite première extrémité du bras de levier tout en permettant la rotation hors-plan dudit bras de levier autour d'une direction de rotation ;
- une deuxième liaison reliée à la seconde extrémité du bras de levier et configurée pour permettre principalement une rotation hors-plan du bras de levier autour d'un axe de rotation s'étendant selon la direction de rotation ;
- une troisième liaison connectant le bras de levier aux moyens de détection à une distance donnée par rapport à l'axe de rotation selon la direction hors-plan , ladite troisième liaison étant adaptée pour autoriser une rotation autour d'un axe de flexion qui suit la même direction que l'axe de rotation mais qui est décalé de la distance donnée selon la direction hors-plan par rapport audit axe de rotation, de sorte à transformer la rotation dudit bras de levier selon ledit axe de rotation en une translation dans le plan du au moins un élément mobile selon une direction de translation.

Selon l'invention, le « plan principal » désigne le plan de référence du dispositif microélectromécanique et/ou nanoélectromécanique, généralement désigné par OXY. Par souci de simplification, le terme « plan » désigne le plan principal. Des plans autres que le plan principal seront désignés différemment. Le terme « hors plan » est en référence audit plan principal.

Les termes « épaisseur », « épais », « minceur », « mince » sont donnés pour des dimensions perpendiculaires au plan du substrat.

Les termes « fin », « finesse », « large », « largeur », « allongé », « allongement », « longueur », « long » sont donnés pour des dimensions dans le plan du substrat (ou dans un plan parallèle au plan du substrat). Dans la présente description, la longueur désigne la dimension selon la direction X et la largeur désigne la dimension selon la direction Y.

Les termes « mobile » et « fixe » se réfèrent au mouvement relatif d'une pièce ou une partie par rapport à l'autre. Le mouvement peut être un déplacement ou une déformation. Ainsi, selon l'invention, le terme « mobile » définit une pièce pouvant se déplacer ou se déformer.

Selon un mode de réalisation, les moyens de détection comprennent une pièce de transmission connectée à le au moins un élément mobile des moyens de détection, la troisième liaison étant reliée à la pièce de transmission de sorte à transmettre la translation selon la direction de translation audit élément mobile par l'intermédiaire de ladite pièce de transmission.

Selon un mode de réalisation avantageux, la liaison mécanique comprend en outre une quatrième liaison de type liaison glissière reliée à le au moins un élément mobile ou à la pièce de transmission, et configurée pour guider ledit élément mobile ou ladite pièce de transmission en translation selon la direction de translation.

Selon un mode de réalisation particulier, la quatrième liaison comprend au moins une simple lame épaisse de flexion dans le plan principal, ladite lame étant fine selon la direction de translation.

Selon un autre mode de réalisation particulier, la quatrième liaison comprend au moins une double lame épaisse de flexion dans le plan principal, chaque lame étant fine selon la direction de translation.

Selon un mode de réalisation, la première liaison comprend au moins une lame épaisse de torsion hors-plan autour d'un axe de torsion parallèle à la direction de rotation.

Selon un mode de réalisation, la deuxième liaison comprend au moins une première lame qui est une lame épaisse de torsion hors-plan autour de la direction de rotation et/ou au moins une deuxième lame qui est une lame de flexion hors-plan autour de ladite direction de rotation, chacune des première et/ou seconde lames étant reliées d'une part au bras de levier et d'autre part à la pièce fixe, par exemple à l'aide d'au moins un plot d'ancrage. La deuxième lame peut être une lame mince ou une lame épaisse.

Selon un mode de réalisation, la troisième liaison comprend une lame de flexion hors plan autour d'un axe de flexion, ladite lame s'étendant selon la direction de translation et étant soit une lame épaisse, soit une lame mince, l'axe de flexion étant parallèle à l'axe de rotation et décalé de la distance donnée par rapport audit axe de rotation selon la direction hors-plan.

Un second objet de l'invention concerne un dispositif de mesure d'une variation de pression comprenant une pièce fixe s'étendant selon le plan principal, une pièce mobile se déplaçant ou se déformant hors-plan sous l'effet d'une variation de pression, des moyens de détection dudit déplacement ou de ladite déformation et une liaison mécanique selon le premier objet de l'invention, ladite liaison mécanique étant configurée pour relier la pièce mobile à au moins un élément mobile des moyens de détection.

Selon un mode de réalisation, la pièce mobile est une membrane souple ou semi-rigide.

Selon un mode de réalisation alternatif, la pièce mobile est un piston rigide.

Selon un mode de réalisation particulier, le dispositif de mesure d'une variation de pression comprend une chambre de mesure à pression réduite, une membrane d'étanchéité fermant au moins partiellement ladite chambre de mesure et des moyens de liaison étanche entre l'intérieur et l'extérieur de ladite chambre de mesure, la première liaison étant disposée à l'extérieur de la chambre de mesure, la deuxième liaison étant reliée aux moyens de liaison étanche, les moyens de détection et la troisième liaison étant disposés dans la chambre de mesure.

Selon un mode de réalisation, les moyens de détection comprennent une électrode mobile connectée à la troisième liaison ou à la pièce de transmission et au moins une électrode fixe, lesdites électrodes s'étendant dans le plan principal et l'entrefer entre l'électrode mobile et la au moins une électrode fixe étant défini par une dimension des électrodes dans le plan principal et par l'épaisseur desdites électrodes, le mouvement de translation transmis par la troisième liaison à l'électrode mobile étant apte à faire varier l'entrefer entre ladite électrode mobile et ladite au moins une électrode fixe selon la direction de translation. Cela permet de former une transduction capacitive à variation d'entrefer.

Selon un mode de réalisation particulier, les électrodes comprennent plusieurs doigts, les doigts de l'électrode mobile étant interdigités avec les doigts de la au moins une électrode fixe, et les doigts des électrodes s'étendent perpendiculairement à la direction de la translation transmise à l'électrode mobile.

Selon un mode de réalisation alternatif, les moyens de détection comprennent une électrode mobile connectée à la troisième liaison ou à la pièce de transmission et au moins une électrode fixe, lesdites électrodes s'étendant dans le plan et les surfaces en regard entre l'électrode mobile et la au moins une électrode fixe étant définies par une dimension des électrodes dans le plan principal et par l'épaisseur desdites électrodes, le mouvement de translation transmis par la troisième liaison à l'électrode mobile étant apte à faire varier les surfaces en regard entre ladite électrode mobile et ladite au moins une électrode fixe selon la direction de translation. Cela permet de former une transduction capacitive à variation de surface.

Selon un mode de réalisation particulier, les électrodes comprennent plusieurs doigts, les doigts de l'électrode mobile étant interdigités avec les doigts de la au moins une électrode fixe et les doigts des électrodes s'étendent dans la direction de la translation transmise à l'électrode mobile.

Selon un mode de réalisation particulier, les moyens de détection comprennent deux électrodes fixes de manière à réaliser une détection différentielle.

Selon un autre mode de réalisation alternatif, les moyens de détection comprenant une poutre de résonance, des moyens d'excitation latérale à ladite poutre et des moyens de mesure de la déformation de ladite poutre selon ladite direction latérale, par exemple des jauges piézorésistives de part et d'autre de la poutre résonante.

Selon un mode de réalisation particulier, le dispositif de mesure d'une variation de pression comprend au moins deux liaisons mécaniques selon le premier objet de l'invention.

### Brève description des figures

D'autres caractéristiques et avantages de l'invention apparaîtront à l'aide de la description qui suit, donnée à titre illustratif et non limitatif, faite en regard des figures annexées parmi lesquelles :
[Fig.1A] et
[Fig.1B] représentent un microphone de l'état de la technique.
[Fig.2] représente une variante d'un microphone de l'état de la technique.
[Fig.3A] et
[Fig.3B] schématisent deux variantes de liaisons mécaniques selon l'invention.
[Fig.4A],
[Fig.4B],

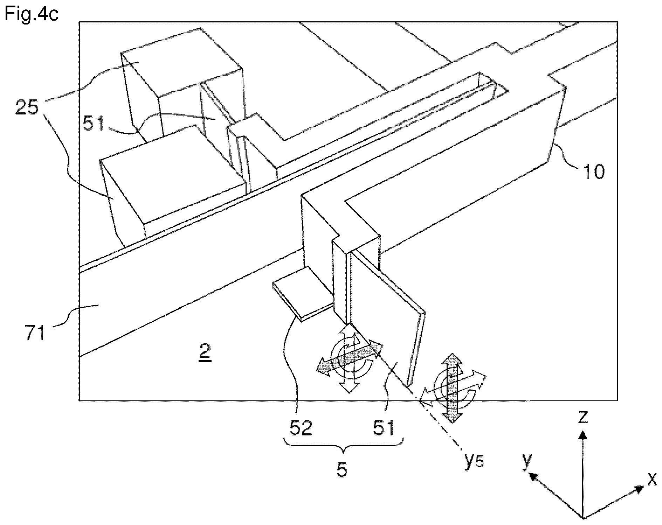

[Fig.4C] et

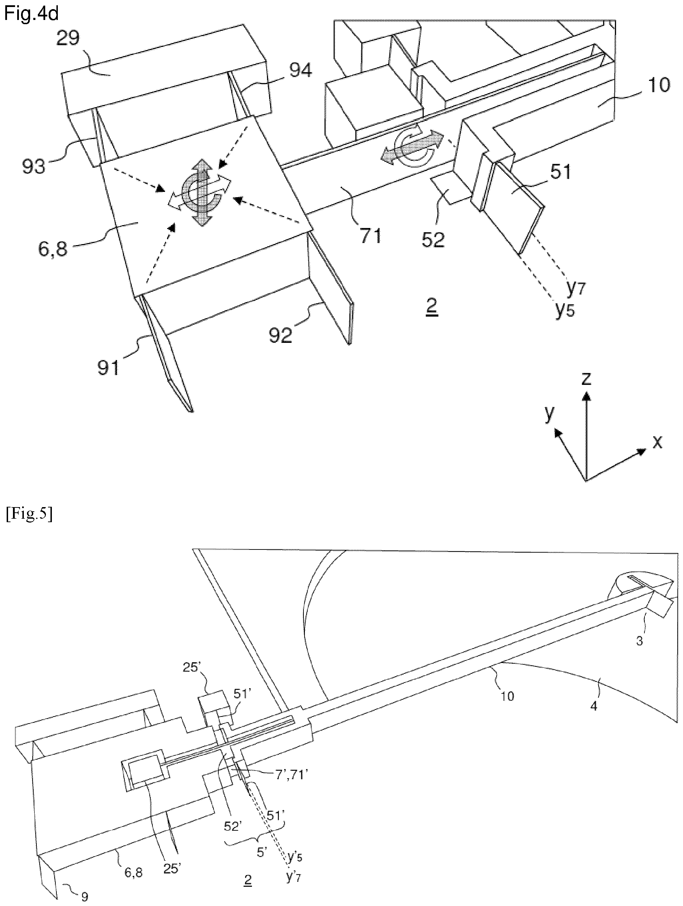

[Fig.4D] représentent différentes vues d'un dispositif de mesure de variation de pression (microphone, capteur de pression) selon un premier mode de réalisation.
[Fig.5] représente une variante de dispositif de mesure de variation de pression selon le premier mode de réalisation.

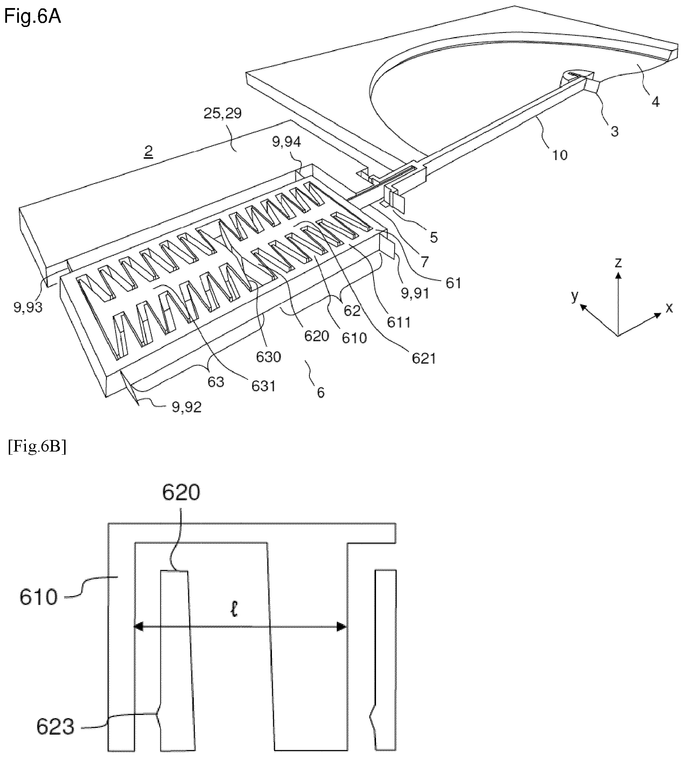

[Fig.6A] représente un dispositif de mesure de variation de pression selon le premier mode de réalisation combiné avec une première variante de transduction capacitive à variation d'entrefer.
[Fig.6B] représente un détail de la première variante de transduction capacitive.

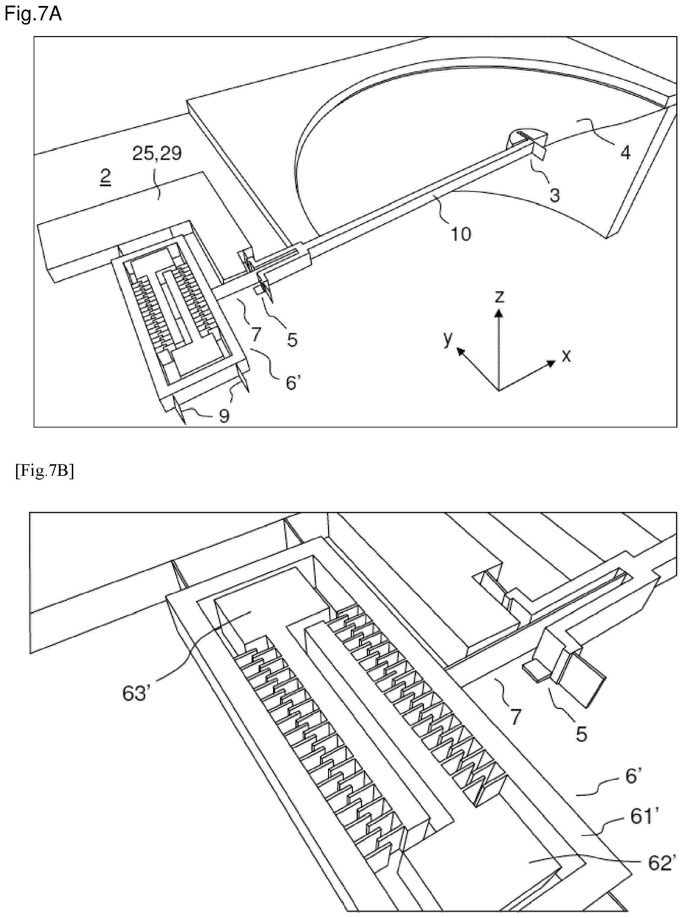

[Fig.7A] et
[Fig.7B] représentent un dispositif de mesure de variation de pression selon le premier mode de réalisation combiné avec une seconde variante de transduction capacitive à variation de surface.

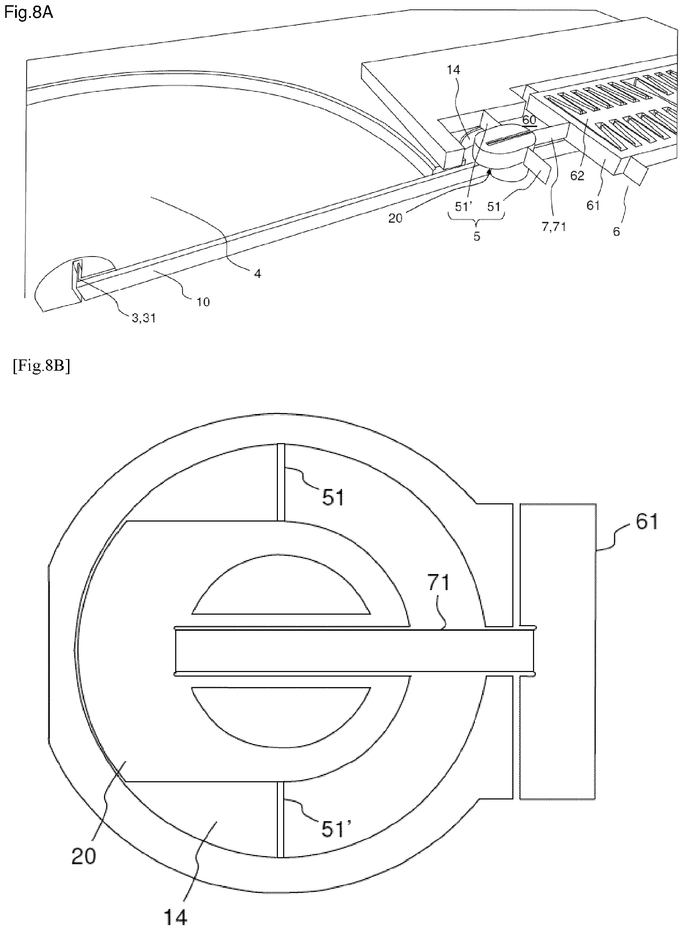

[Fig.8A] représente un dispositif de mesure de variation de pression selon un second mode de réalisation.
[Fig.8B] représente un détail du dispositif de mesure de variation de pression selon le second mode de réalisation.
[Fig.9A],
[Fig.9B],

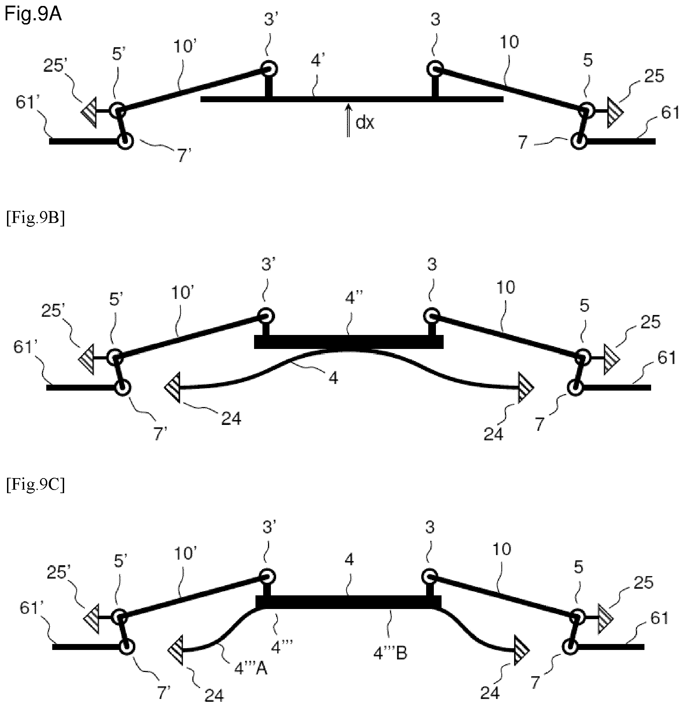

[Fig.9C] schématisent trois autres variantes de liaisons mécaniques selon l'invention.

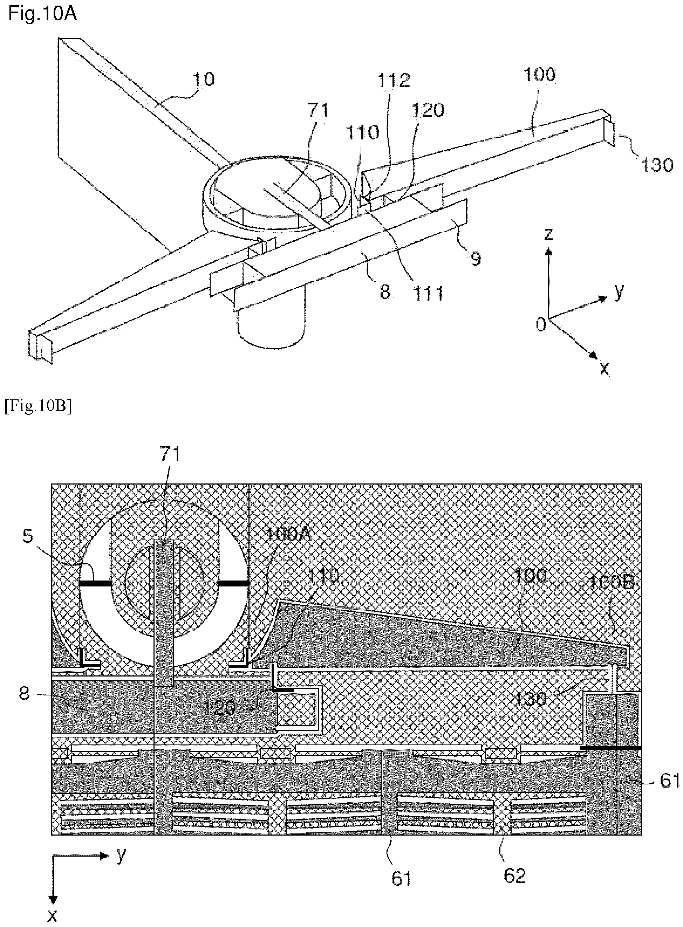

[Fig.10A] et
[Fig.10B] représentent un dispositif de mesure de variation de pression selon un troisième mode de réalisation.

### Description détaillée de l'invention

Dans l'ensemble de la présente description détaillée, le plan principal (ou « plan ») est désigné par la référence OXY et correspond généralement au plan du substrat sur lequel la structure MEMS-NEMS est fabriquée. La direction hors-plan est représentée par la direction Z. La direction de translation dans le plan principal est représentée par la direction X. La direction de rotation hors-plan est représentée par la direction Y.

Dans l'ensemble de la présente description détaillée, les éléments remplissant les mêmes fonctions et réalisés de manière similaire structurellement sont généralement désignés par une même référence. Les éléments remplissant les mêmes fonctions mais réalisés de manière différente structurellement sont généralement désignés par des références différentes.

Les figures 1A, 1B et 2 ont été décrites précédemment et ne seront pas reprises ici.

L'invention consiste à transformer un mouvement (déformation ou déplacement) hors-plan d'une pièce mobile (membrane, piston par exemple) en un mouvement de translation dans un plan. Le mouvement de translation obtenu est transmis à des moyens de détection pour être mesuré et en déduire le mouvement de la pièce mobile (par exemple la déformation de la membrane, le déplacement du piston ...). Par exemple, le mouvement de translation peut être transmis à une électrode mobile de manière à la déplacer en translation dans un plan relativement à une électrode fixe, ce qui forme un moyen de détection capacitif.

Dans l'ensemble de la description détaillée, le plan désigne le plan du support du dispositif de mesure, par exemple du substrat, ou un plan parallèle audit plan du support.

Les figures 3A et 3B schématisent deux variantes de liaisons mécaniques selon l'invention dans le cas d'une membrane 4 se déformant selon la direction hors-plan Z sous l'effet d'une différence de pression entre ses deux faces, la liaison mécanique reliant la membrane à des moyens de détection et permettant de transformer la déformation hors-plan de la membrane en un mouvement de translation dans le plan OXY selon la direction de translation X. Les extrémités de la membrane 4 sont ancrées sur la pièce fixe, par exemple sur un substrat (non représenté sur les figures 3A et 3B), par un moyen d'ancrage 24.

Dans les deux variantes représentées, la liaison mécanique 1 relie la membrane 4 à une électrode mobile 61 qui, avec au moins une électrode fixe (non représentée sur ces figures), fait partie d'un bloc de détection 6 capacitive. La liaison mécanique 1 comprend :
- un bras de levier 10 de longueur L ;
- une première liaison 3 reliant la membrane 4 en son centre à une première extrémité 10.1 du bras de levier 10 ;
- une deuxième liaison 5 (ou liaison pivot) reliée à la seconde extrémité 10.2 du bras de levier 10 et fixée au substrat (non représenté) par un moyen d'ancrage 25;
- une troisième liaison 7 (ou liaison de couplage) qui connecte le bras de levier 10 à l'électrode mobile 61 avec un décalage d'une distance d dans la direction hors-plan Z.

La première liaison 3 permet la transmission des mouvements hors-plan de la membrane 4 à la première extrémité 10.1 du bras de levier 10. La première liaison peut être formée par une lame rigide dans la direction hors-plan Z pour transmettre audit bras de levier une translation selon ladite direction hors-plan. Cela peut être une lame épaisse, large selon une la direction Y et fine selon la direction X de manière à autoriser la torsion autour d'un axe de torsion Y3 s'étendant selon la direction de rotation Y.

La deuxième liaison 5 permet de suivre la translation hors-plan transmise à la première extrémité 10.1 du bras de levier 10 par la première liaison 3, tout en imposant une rotation dudit bras de levier autour d'un axe de rotation Y5 formé au niveau de la seconde extrémité 10.2 dudit bras de levier et s'étendant selon la direction Y.

La deuxième liaison peut être obtenue par au moins une lame épaisse pour bloquer la translation selon la direction Z et souple en torsion autour de la direction Y associée à au moins une lame longue selon la direction X pour bloquer la translation selon X et souple en flexion autour de la direction Y. Cette deuxième liaison peut être nommée « liaison pivot ».

Ainsi, lorsque la membrane se déforme (variation dz) sous l'effet d'une différence de pression entre ses deux faces, elle entraine en un mouvement de translation hors-plan la première extrémité 10.1 du bras de levier 10 par la première liaison 3, lequel bras de levier est maintenu en rotation hors-plan au niveau de sa seconde extrémité 10.2 par la deuxième liaison 5. Comme la première liaison 3 est rigide dans la direction hors-plan Z, elle transmet le déplacement hors plan de la membrane à la première extrémité 10.1 du bras de levier 10. En outre elle autorise la rotation du bras de levier 10 autour de son axe de rotation Y5 et un fléchissement selon la direction X de par sa souplesse (finesse) selon ladite direction X, ce qui permet de faire cohabiter la translation de la membrane 4, purement en Z, et le déplacement en arc de cercle de la première extrémité 10.1 du bras de levier, résultant de la rotation dudit bras de levier.

La troisième liaison 7 connecte la seconde extrémité 10.2 du bras de levier 10 à l'électrode mobile 61. Cette troisième liaison 7 autorise une rotation selon un axe de flexion Y7 qui suit la même direction Y que l'axe de rotation Y5 mais qui est avantageusement décalé (d'une distance d) selon la direction Z par rapport à la deuxième liaison 5. Ainsi, en premier ordre, la troisième liaison permet de transformer la rotation du bras de levier 10 en une translation de l'électrode 61 selon la direction X. La troisième liaison doit donc transmettre une translation selon la direction X, tout en autorisant la rotation du bras de levier autour de la direction Y. En second ordre, elle doit également absorber une légère translation selon la direction Z : comme la première liaison 3, elle doit faire cohabiter la rotation du bras de levier 10 avec une translation. Cette troisième liaison peut être nommée « liaison de couplage ».

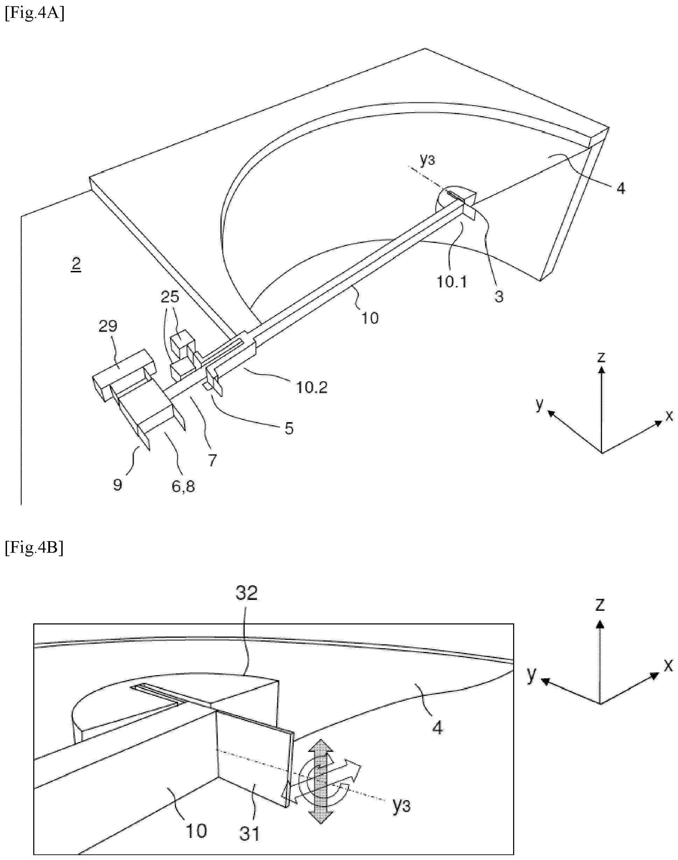

L'électrode mobile 61 est avantageusement guidée en translation selon la direction X par une quatrième liaison 9 de type liaison glissière (représentée sur la figure 4A par exemple).

La différence entre les deux variantes illustrées par les figures 3A et 3B est que le décalage selon la direction Z entre la deuxième et la troisième liaison n'est pas dans le même sens. Dans la variante de la figure 3A, la deuxième liaison est au-dessus de la troisième liaison alors que dans la variante de la figure 3B, la deuxième liaison est en dessous de la troisième liaison. Une configuration ou une autre pourra ainsi être choisie en fonction du design de la structure.

Selon une variante de réalisation, la troisième liaison 7 peut connecter la seconde extrémité 10.2 du bras de levier 10 à une pièce de transmission 8 qu'elle entraine en translation dans le plan, laquelle pièce de transmission transmet à son tour une translation à une électrode mobile 61 (ou à une jauge de contrainte, à une poutre de résonance, ou à tout autre moyen pour permettre une détection de mouvement de translation dans le plan).

Les figures 4A à 4D représentent différentes vues d'un dispositif de mesure de variation de pression MEMS-NEMS selon un premier mode de réalisation. Il peut s'agir d'un microphone ou d'un capteur de pression absolu ou différentiel. Pour plus de lisibilité, certaines parties, comme par exemple les plots d'ancrage, ne sont représentées que dans un demi-plan. En outre, les flèches grises indiquent les directions de couplage des liaisons et les flèches blanches indiquent les directions souples des liaisons.

Dans les figures 4A à 4D, les moyens de détection 6 de mouvement (par exemple détection capacitive) ne sont pas représentés en détail mais schématisés par un bloc de détection. Même si seulement certains un (des) élément(s) formant le bloc de détection est (sont) mobile(s), c'est-à-dire déformable(s) ou déplaçable(s), on dira par simplification que le mouvement de translation est transmis au bloc de détection : il faut donc comprendre par-là que le mouvement de translation est transmis au(x) seul(s) élément(s) mobile(s) du bloc de détection.

Le mouvement de translation peut être transmis au(x) élément(s) mobile(s) directement, ou indirectement par l'intermédiaire d'une pièce de transmission 8. Dans ce dernier cas, on peut considérer par convention que la pièce de transmission 8 fait partie du bloc de détection 6 et la troisième liaison 7 de couplage relie le bras de levier 10 à la pièce de transmission 8, laquelle pièce de transmission transmet la translation dans le plan à l'(aux) élément(s) mobile(s) du bloc de détection.

Un élément mobile des moyens de détection peut être une électrode mobile en déplacement (détection capacitive), une jauge de contrainte qui se déforme (détection piézoélectrique ou piézorésistive), une poutre de résonance (détection par résonance) ou tout autre élément mobile permettant une détection de mouvement de translation dans le plan.

Le dispositif représenté comprend une membrane 4 réalisée dans la couche mince (NEMS) avec par exemple une épaisseur de l'ordre de 1 µm afin que la membrane assure une étanchéité tout en restant souple. Dans le cas d'un microphone, l'étanchéité n'est pas obligatoire.

Le déplacement du centre de la membrane est transféré à une première extrémité 10.1 d'un bras de levier 10 grâce par une première liaison 3 que l'on peut voir sur les figures 4A et 4B.

La première liaison 3 est formée par au moins une lame épaisse 31 de torsion et par un élément de fixation 32 de la lame épaisse 31 sur la membrane. De par la forte épaisseur de cette lame, la première liaison a l'avantage de coupler fortement la translation hors-plan (selon la direction Z). En outre, la finesse de la lame 31 dans la direction X autorise un angle de torsion autour d'un axe de torsion Y3 selon la direction Y ainsi qu'une flexion selon la direction X. Ces deux degrés de liberté de la lame épaisse 31 évitent de rendre hyperstatique la connexion entre l'extrémité 10.1 du bras de levier en rotation et le centre de la membrane 4 en translation.

Le bras de levier 10 est de préférence gravé dans la couche épaisse (MEMS) pour obtenir une rigidité suffisante.

La seconde extrémité 10.2 du bras de levier est reliée à une deuxième liaison 5 (liaison pivot) à la base de la couche épaisse.

La deuxième liaison 5 est formée par deux lames épaisses de torsion 51 et deux lames minces de flexion 52 hors plan (détail en figure 4C). Chaque lame est reliée d'une part au bras de levier 10 et d'autre part au substrat 2 de la structure MEMS-NEMS, à l'aide d'un plot d'ancrage 25. Le substrat 2 s'étend dans le plan OXY. Les lames de torsion 51, gravées dans la couche épaisse, bloquent la translation hors plan grâce à leur forte raideur de flexion en Z et leur ancrage, tout en présentant une faible raideur angulaire grâce à leur faible longueur selon la direction X, autorisant une torsion autour de la direction Y. Les lames de flexion 52 hors-plan, gravées dans la couche mince, bloquent la translation dans la direction X grâce à leur forte raideur de compression et leur ancrage, tout en présentant une faible raideur angulaire grâce à leur faible épaisseur, autorisant une flexion autour de la direction Y. La combinaison des deux lames épaisses de torsion 51 et deux lames minces de flexion 52 bloque ainsi les translations hors plan et dans le plan, tout en autorisant une rotation du bras de levier 10 autour d'un axe de rotation Y5 selon la direction de rotation Y. L'axe de rotation est ainsi défini à la base de la couche épaisse (MEMS) des lames de torsion 51, à l'intersection du coeur de la couche mince (NEMS) des lames de flexion 52 et du coeur des lames de torsions 51. La première liaison pivot 5 autorise ainsi une rotation du bras de levier 10 autour de l'axe de rotation Y5, donc une rotation hors plan par rapport au substrat 2.

La troisième liaison 7 (liaison de couplage) adaptée pour transmettre le mouvement de rotation du bras de levier 10 en un mouvement de translation au bloc de détection 6 consiste en une lame épaisse 71 de flexion hors plan reliée d'une part au bras de levier 10 et d'autre part au bloc de détection 6. La forte raideur en compression selon la direction X de cette lame épaisse et longue selon la direction X (détail en figure 4D), permet de transmettre aux moyens de détection 6 le déplacement selon la direction X du bras de levier 10 au niveau du milieu de ladite lame. Une faible flexion hors plan autour d'un axe de flexion Y7 parallèle à la direction Y suffit à obtenir une connexion non hyperstatique entre la rotation hors-plan du bras de levier 10 autour de la direction Y et la translation selon la direction X du bloc de détection 6. En d'autres termes, même si la lame épaisse de flexion 71 présente une forte épaisseur, sa rotation en flexion autour de la direction hors-plan Z permise par sa finesse selon la direction X et le faible mouvement de flexion hors plan autour de l'axe de flexion Y7 parallèle à la direction Y permettent de faire cohabiter la rotation du bras de levier 10 et la translation de l' (des) élément(s) mobile(s) du bloc de détection 6.

Avantageusement, la lame épaisse 71 de couplage est centrée autour de son axe de flexion Y7. Sa déformation est alors une flexion angulaire pure, c'est là qu'elle opposera le moins de raideur.

Comme l'axe de flexion Y7 de la troisième liaison 7 apparait au milieu de l'épaisseur MEMS, on obtient bien l'excentricité nécessaire entre la seconde liaison et la troisième liaison. La lame épaisse de flexion hors-plan formant la liaison de couplage 7 peut donc être vue comme une biellette connectée entre le bras de levier 10 et le bloc de détection 6.

Le bloc de détection 6 est avantageusement maintenu en translation selon la direction X par une quatrième liaison 9 (également nommée liaison glissière) apte à guider la translation dans le plan. Comme représenté plus en détail en figure 4D, la liaison glissière 9 comprend plusieurs lames épaisses 91, 92, 93, 94 de flexion dans le plan. Ces lames présentent une forte raideur hors-plan, due à leur forte épaisseur. De plus, leur forte raideur en compression selon la direction Y permet de bloquer la translation selon cette direction Y. Enfin, leur faible longueur selon la direction X génère une faible raideur en fléchissement dans cette direction X. Cela permet de guider la translation transmise au bloc de détection 6 selon la direction X.

Selon un mode avantageux, au moins trois lames épaisses 91, 92, 93 de flexion forment la liaison glissière 9, ce qui permet de bloquer toute rotation dans le plan OXY. Alternativement, deux lames épaisses suffisamment éloignées entre elles selon la direction X suffisent à bloquer la rotation dans le plan OXY. Dans le mode illustré, il y a quatre lames épaisses 91, 92, 93, 94 de flexion, ce qui permet d'améliorer la symétrie.

Selon une variante de réalisation, dans laquelle le bloc de détection 6 comprend une pièce de transmission 8 connectée à la troisième liaison 7, laquelle pièce de transmission entraine à son tour une électrode mobile en translation, une jauge de contrainte, une poutre de résonance ou tout autre moyen pour permettre une détection de mouvement de translation dans le plan, la liaison glissière 9 est reliée à la pièce de transmission 8 de manière à guider celle-ci en translation dans le plan.

Selon une variante du premier mode de réalisation (mode de la figure 3A, illustré en figure 5), la deuxième liaison 5' ou liaison pivot peut être formée par deux lames épaisses 51' de torsion de type de celles illustrées en figures 4C et 4D (référence 51) et au moins une lame épaisse 52' de flexion hors plan du type de celle illustrée en figures 4C et 4D (référence 71). Dans ce cas, la lame épaisse de flexion hors plan est reliée au substrat 2 par un plot d'ancrage et non au bloc de détection 6 ou à la pièce de transmission 8. La lame épaisse de flexion hors plan est reliée d'autre part au bras de levier 10. L'axe de rotation Y5' du bras de levier est alors au milieu de la couche épaisse MEMS (et non plus au pied de la couche épaisse i.e. non plus au coeur de la couche mince NEMS). Par ailleurs, la troisième liaison ou liaison de couplage 7' est alors formée par les lames minces 71' en flexion hors plan de type de celles illustrées en figures 4C et 4D (référence 52). Celles-ci, au lieu d'être liées à des plots d'ancrage sont reliées au bloc de détection 6 ou à la pièce de transmission 8. L'axe de flexion Y7' est alors non plus au-dessus de l'axe de rotation Y5' mais en dessous, au coeur de la couche mince et plus au milieu de la couche épaisse.

Les figures 6A et 6B représentent un dispositif de mesure de variation de pression MEMS-NEMS selon le premier mode de réalisation combiné avec une première variante de bloc de détection 6 formant une transduction capacitive à variation d'entrefer. Un tel bloc de détection peut être mis en oeuvre pour un dispositif de mesure de variation de pression MEMS-NEMS selon l'invention, notamment, mais pas uniquement, pour un dispositif de mesure de variation de pression MEMS-NEMS selon un des modes de réalisation. Le dispositif comprend une membrane 4 connectée à un bras de levier 10 par une première liaison 3, une deuxième liaison 5 permettant la rotation hors-plan du bras de levier 10 et une troisième liaison 7 apte à transformer la rotation hors-plan du bras de levier en un mouvement de translation dans le plan appliquée à une électrode mobile 61.

Le bloc de détection capacitif 6 représenté comprend ainsi une électrode mobile 61 qui est entraînée en translation dans le plan (selon une direction X) grâce à la liaison de couplage 7 et deux électrodes fixes 62, 63. Chaque électrode 61, 62, 63 est formée par une série de doigts 610, 620, 630 formant un peigne. Les doigts 610 de l'électrode mobile 61 sont reliés entre eux par un cadre ou poutre de rigidification 611. Les doigts 620, 630 des électrodes fixes 62, 63 sont reliés entre eux par une poutre centrale de rigidification 621, 631. Le peigne d'une électrode fixe est interdigité avec le peigne de l'électrode mobile (et réciproquement).

Les électrodes sont réalisées dans la couche épaisse (MEMS).

Avantageusement, comme illustré en figure 6B, au moins un doigt de l'électrode fixe 62 comprend une butée 623 s'étendant vers le doigt de l'électrode mobile qui se situe en vis-à-vis dans le même entrefer, de manière à éviter que les surfaces des deux doigts ne se collent lorsqu'elles viennent en contact (c'est-à-dire lorsque l'entrefer tend vers zéro). La butée peut être remplacée par tout autre moyen remplissant la même fonction et/ou elle peut-être disposée sur au moins un doigt de l'électrode mobile.

L'électrode mobile 61 est maintenue en translation dans le plan grâce à des lames épaisses simples 91, 92, 93, 94 en flexion dans le plan formant une liaison glissière 9. Ces lames présentent une forte raideur hors-plan, due à leur forte épaisseur. De plus, leur forte raideur en compression selon la direction Y permet de bloquer la translation selon cette direction Y. Enfin, leur faible longueur selon la direction X génère une faible raideur dans cette direction X. Cela permet de guider la translation de l'électrode mobile 61 selon la direction X.

Selon une variante de réalisation, une liaison glissière peut comprendre des doubles lames au lieu de lames simples. Une double lame comprend deux lames simples en flexion dans le plan se rejoignant en formant un U, chaque lame étant allongée selon la direction Y et fine selon la direction X, une première lame étant reliée à l'électrode mobile et une seconde lame étant reliée au support fixe, ou substrat, les deux lames étant reliées entre elles par une pièce de liaison intermédiaire. Cette configuration permet une raideur beaucoup plus linéaire lors du déplacement de l'électrode dans la direction souhaitée X, notamment lors de forts déplacements, même si cela fournit moins de raideur selon la direction Y.

Contrairement à la transduction capacitive de l'état de la technique, notamment illustrée en figure 1B, dans laquelle l'électrode a un mouvement vertical (mouvement hors-plan), la transduction capacitive rendue possible par l'invention est réalisée par un mouvement horizontal (mouvement plan) de l'électrode mobile. L'invention permet ainsi de répondre aux problèmes posés par les microphones (ou les capteurs de pression) à détection capacitive de l'état de la technique, et expliqués plus avant en lien avec les figures 1B et 2, comme expliqué dans ce qui suit.

D'une part, selon l'invention, l'entrefer n'est pas limité par l'épaisseur des couches sacrificielles mais il est défini par une dimension dans le plan en plus de l'épaisseur. Or cette dimension dans le plan n'est pas limitée comme l'est l'épaisseur et on peut définir une dimension spécifique des doigts de l'électrode mobile et/ou de l'électrode fixe notamment pour définir un entrefer donné, et ce, par des dessins de masques spécifiques. Ainsi, par exemple, un entrefer de quelques centaines de nanomètres à quelques microns peut être obtenu par gravure de la couche épaisse (MEMS). Actuellement, l'état de la technique permet au rapport d'aspect entre l'entrefer et l'épaisseur de la couche d'atteindre seulement des valeurs de 1/20 à 1/30.

D'autre part, les poutres sont principalement sollicitées en compression ou tension (dans le plan) plutôt qu'en flexion (hors-plan), elles sont donc sollicitées là où elles sont intrinsèquement plus rigides. Cela permet de réduire la masse des poutres de rigidification et donc la masse totale des électrodes, à déformation constante, mais aussi de dessiner des électrodes plus grandes que celles de l'état de la technique qui sont, elles, limitées par la raideur et les déformations hors plan.

On peut aussi élargir les poutres aux endroits les plus sollicités et au contraire les affiner là où les efforts sont moindres. C'est notamment ce qui est fait au niveau des doigts capacitifs, dessinés en forme de triangle. En améliorant le rapport rigidité sur taille, cette astuce permet d'augmenter la densité de doigts et de minimiser leur masse. Limiter la masse des électrodes mobiles permet d'augmenter la fréquence de résonance. Ce point est important pour les microphones qui doivent mesurer des signaux jusqu'à 20kHz. C'est encore plus vrai pour les microphones à ultra-sons.

Dans le mode de réalisation illustré dans la figure 6A, la détection est différentielle. Il y a en effet deux électrodes fixes : une première électrode fixe 62 qui est représentée sur la partie droite du bloc de détection capacitif 6 pour laquelle les doigts 620 sont disposés à gauche des doigts 610 de l'électrode mobile 61 et une seconde électrode fixe 63 qui est représentée sur la partie gauche du bloc de détection capacitif 6 pour laquelle les doigts 630 sont disposés à droite des doigts 610 de l'électrode mobile 61. Ainsi quand l'électrode mobile se déplace sur la droite, cela augmente l'entrefer avec la première électrode fixe et cela diminue l'entrefer avec la seconde électrode fixe et inversement. La détection différentielle améliore la lecture des capacités. Elle apporte un autre avantage qui est d'équilibrer les forces électrostatiques. En effet, les doigts s'attirent mutuellement. Ici, l'électrode fixe à gauche attire l'électrode mobile vers la gauche, et l'électrode fixe à droite attire l'électrode mobile vers la droite. Ces deux forces s'opposent et s'annulent à travers des contraintes en compression dans le cadre de l'électrode mobile.

Alternativement, il pourrait n'y avoir qu'une seule électrode fixe.

Un autre avantage de l'invention est que la détection différentielle est plus facile à réaliser dans le plan, avec des dessins de masques spécifiques, alors que dans les détections différentielles de l'art de la technique, notamment illustré en figure 1B, cela nécessite de prévoir deux couches sacrificielles, généralement de même épaisseur.

Enfin, l'invention, en permettant de générer un mouvement de l'électrode mobile 61 dans le plan, permet d'augmenter la densité capacitive. La Figure 6B permet d'illustrer cet avantage en zoomant sur un doigt d'une électrode fixe entre deux doigts de l'électrode mobile. On peut voir par exemple qu'il est possible de réaliser des motifs unitaires de longueur 1 égale à 8µm. Par ailleurs les électrodes sont dans la couche épaisse (MEMS) et peuvent atteindre une épaisseur de 20µm. Dans cet exemple, la surface en regard est donc 2,5 fois plus grande que la surface occupée alors que dans la détection hors plan, la surface en regard correspond seulement à la surface occupée.

Les figures 7A et 7B illustrent une seconde variante de bloc de transduction capacitive dans le plan dans laquelle le bloc de transduction capacitive 6' est configuré différemment. Dans cette variante, il y a également une électrode mobile 61' et deux électrodes fixes 62', 63' mais elle se distingue de la première variante en ce que les doigts des électrodes s'étendent dans la direction de la translation transmise à l'électrode mobile 61' (alors que dans la première variante, les doigts s'étendent dans la direction perpendiculaire dans le plan à la direction de la translation transmise à l'électrode mobile 61). Ainsi, cela permet de réaliser une détection capacitive par variation de surface.

La détection par variation d'entrefer est bien adaptée aux faibles déplacements, car elle fournit une plus grosse variation de capacité pour un déplacement donné. Cependant, à fort déplacement, elle devient non linéaire et la détection à variation de surface selon cette seconde variante est alors plus adaptée. D'autre part, lorsque l'électrode n'est pas placée dans le vide, la variation d'entrefer va s'accompagner d'un effet dit « squeeze film damping » qui correspond à un pincement du film d'air entre deux électrodes. Ce phénomène entraine un amortissement, et donc du bruit. Une variation de surface crée moins de bruit mécanique. Enfin, l'effet non linéaire de la variation d'entrefer, au premier ordre, peut être utilisé pour obtenir une raideur négative dépendant de la tension de polarisation, et ainsi régler la fréquence de résonance du dispositif.

Les deux variantes de blocs de détection capacitive peuvent être mises en oeuvre pour un dispositif de mesure de variation de pression MEMS-NEMS selon l'invention, notamment, mais pas uniquement, pour un dispositif de mesure de variation de pression MEMS-NEMS selon un des modes de réalisation.

Les figures 8A et 8B représente un dispositif de mesure de variation de pression selon un second mode de réalisation qui se distingue du premier mode en ce que la transduction électrique est réalisée dans une cavité de mesure 60 à pression réduite, voire sous vide, comme pour le dispositif MEMS-NEMS de mesure d'une variation de pression décrit dans la demande de brevet FR3059659. L'articulation pivot de la demande de brevet, représentée sur la Figure 1A, qui permet d'articuler en rotation hors-plan l'élément de transmission 20, est réalisée par des lames épaisses de torsion 22.1 et 22.2 (qui bloquent les translations hors plan) et la membrane d'étanchéité 16 (qui bloque les déplacements dans le plan). Dans la demande de brevet FR3059659, l'élément de transmission 20 est rigide ou peu déformable. Le mouvement transmis par l'élément de transmission, et en particulier par le deuxième bras de transmission 20.2 à l'électrode mobile 21 dans la chambre de mesure est un mouvement hors-plan.

L'invention permet de transformer le mouvement hors-plan en une translation dans le plan en remplaçant le deuxième bras de transmission rigide par une troisième liaison 7 et notamment une lame épaisse 71 en flexion hors plan formant la troisième liaison 7 de la liaison mécanique selon l'invention.

Ainsi, dans le second mode de réalisation en référence à la figure 8A (vue de dessous), la liaison mécanique selon l'invention comprend :
- un bras de levier 10 ;
- une première liaison 3 formée par au moins une lame de torsion 31 et qui relie la membrane 4 au bras de levier 10 ;
- une deuxième liaison 5 formée par les deux lames épaisses de torsion 51 et 51' et par la membrane d'étanchéité 16 ;
- une troisième liaison 7 formée par une lame épaisse 71 en flexion hors-plan qui permet de transmettre une translation à une électrode mobile 61 disposée dans la cavité de mesure 60 à pression réduite.

En outre, le dispositif de mesure de variation de pression comprend une membrane d'étanchéité 14 liée à un élément de transmission mécanique 20 entre l'environnement extérieur et la cavité de mesure 60, le tout formant étanchéité entre l'environnement extérieur et la cavité de mesure. L'élément de transmission 20 relie de manière étanche les deux milieux tout en assurant la liaison mécanique entre le bras de levier 10 et la troisième liaison 7. En cela il est relié à la deuxième liaison 5.

Dans ce second mode de réalisation, on dispose de deux couches épaisses MEMS (une couche épaisse dans la cavité à pression réduite et une couche épaisse dans l'air). Les lames épaisses de torsions 51 et 51' sont disposées dans la cavité à pression réduite mais elles pourraient être implémentées dans n'importe quelle couche, voire chacune dans une couche différente.

La troisième liaison 7, c'est-à-dire ici la lame épaisse 71, est disposée dans la cavité de mesure à pression réduite.

La lame épaisse 71 est reliée à une électrode mobile 61 qui est ainsi animée d'un mouvement de translation dans le plan dans la cavité à pression réduite. La capacité représentée 6 est celle de la première variante des figures 6A et 6B. Alternativement, elle pourrait être celle de la seconde variante des figures 7A et 7B, ou toute autre capacité adaptée.

Alternativement à une transduction capacitive, le bloc de détection 6 peut comprendre une poutre de résonance afin de réaliser une détection par résonance. Cette alternative s'applique à tous les modes de réalisation, et plus largement à tout dispositif de mesure de variation de pression MEMS-NEMS selon l'invention. Cependant, il est avantageux de réaliser la détection par résonance dans une cavité à pression réduite, c'est-à-dire par exemple selon le deuxième ou le troisième mode de réalisation décrit plus après. En effet, pour obtenir un bon coefficient de qualité, l'amortissement visqueux d'un résonateur doit être réduit en le plaçant dans une atmosphère raréfiée.

Le bloc de détection peut alors comprendre une poutre de résonance avantageusement disposée dans une cavité à pression réduite, le mouvement de la membrane ou du piston étant transformé grâce à la liaison mécanique de l'invention en un mouvement de translation dans le plan transmis à la poutre de résonance qui peut ainsi être compressée ou étirée dans le plan. Le stress induit par la compression ou la tension de la poutre décale les modes de résonance de la poutre. En excitant latéralement la poutre, par exemple par une force électrostatique, et en mesurant sa déformation selon cette direction latérale, par exemple par des jauges piézorésistives sur les côtés de la poutre résonante, on peut trouver puis suivre les modes de résonances de ladite poutre. En mesurant par exemple la fréquence du premier mode de déformation, on peut avoir l'image du déplacement de la poutre de résonance et remonter au mouvement de la membrane et du piston, et ainsi avoir une valeur de variation de pression.

Comme le bras de levier est en rotation, le déplacement des éléments qui y sont connectés est proportionnel à leur distance par rapport au centre de rotation dudit bras de levier. Dans les cas décrits précédemment (figures 3A à 8B), la longueur du bras de levier L est supérieure au rayon de la membrane pour récupérer le mouvement en son centre (quelques centaines de microns), et l'excentricité d entre les deuxième et troisième liaisons est égale à la moitié de l'épaisseur MEMS (une dizaine de microns). Par conséquent, le déplacement de l'électrode sera plus d'un ordre de grandeur inférieur au déplacement de la membrane.

La membrane 4 peut avantageusement être remplacée par un piston 4'. Un piston peut être détouré et rigidifié et il peut présenter n'importe quelle forme. Un piston parallélépipédique, connecté au bras de levier en son centre, permet de réduire mécaniquement la taille du bras de levier si l'on diminue la longueur du piston dans la direction longitudinale du bras de levier (direction X dans les figures) tout en augmentant la largeur du piston dans la direction transversale du bras de levier (direction Y dans les figures), et ce dans les mêmes proportions pour conserver une surface constante du piston.

Alternativement, on peut utiliser plusieurs bras de levier répartis autour de la membrane ou du piston et les connecter (à l'aide d'autant de premières liaisons) non plus au centre de ladite membrane ou dudit piston, mais à l'une de ses extrémités. De préférence, les bras de levier sont uniformément répartis autour de la membrane ou du piston.

Les figures 9A, 9B et 9C représentent trois variantes de réalisation de la solution à deux bras de levier.

La figure 9A représente un piston rigide 4' relié à deux bras de levier 10, 10' au niveau de chacune de ses extrémités. Le piston est typiquement constitué d'une armature de poutres épaisses dans la couche MEMS pour être rigide, recouverte d'une membrane fine NEMS sur toute la surface formée par l'armature, pour être léger. Dans cette variante de réalisation, deux premières liaisons 3, 3' connectent les premières extrémités de deux bras de levier 10, 10' sur l'armature MEMS en bord de piston.

La figure 9B représente une membrane souple 4 connectée en son milieu, comme dans les figures 3A à 8B. La différence est que la membrane souple 4 est reliée à deux premières liaisons 3, 3' par l'intermédiaire d'une poutre rigide 4" et ce, aux deux bords de ladite poutre rigide. La poutre rigide 4" est une poutre épaisse de la couche MEMS, et a pour fonction de transmettre la translation du centre de la membrane vers les bras de levier.

La figure 9C représente une membrane 4‴ comprenant une partie souple 4‴ A et une partie rigide 4"'B reliée à deux bras de levier 10, 10' au niveau de chacune de ses extrémités par deux premières liaisons 3, 3'.

Ces trois variantes nécessitent de réaliser deux premières liaisons 3, 3', deux deuxièmes liaisons 5, 5' et deux troisièmes liaisons 7, 7'. En outre, les moyens de détection 6 doivent comprendre deux éléments mobiles 61, 61'. Cela revient à utiliser plusieurs liaisons mécaniques selon l'invention. Ces trois variantes de réalisation peuvent être obtenues en utilisant la couche mince et/ou la couche épaisse pour réaliser les différentes pièces.

Dans les trois variantes, les bras de levier ont été raccourcis car ils n'ont plus besoin de se connecter au centre de la membrane.

Les bras de levier sont avantageusement uniformément répartis pour éviter que le piston rigide ne vrille sous l'effet d'un moment résultant.

Les figures 10A et 10B représentent un troisième mode de réalisation qui permet d'augmenter le déplacement horizontal. Dans ce troisième mode, comme dans le second mode, la transduction électrique est réalisée dans une cavité à pression réduite, voire sous vide. Alternativement, la transduction pourrait ne pas être réalisée dans une telle cavité, comme dans le premier mode. En outre, un bras de levier supplémentaire 100 placé à la suite du bras de levier 10, fournit un gain en déplacement qui compense la perte du gain dudit bras de levier. Comme précédemment, la liaison mécanique transmet un mouvement selon X à la pièce de transmission 8 via une lame de flexion hors plan 71. Cette pièce de transmission 8 entraine en rotation dans le plan OXY un bras de levier 100 supplémentaire, grâce à une première lame de couplage 120, ledit bras de levier supplémentaire étant maintenu en rotation par une charnière 110. La première lame de couplage et la charnière sont disposées à une première extrémité 100A dudit bras de levier. La charnière 100 est réalisée par deux lames épaisses 111 et 112 perpendiculaires entre elles dont le croisement définit l'axe de rotation selon la direction Z. La première lame de couplage 120 est épaisse selon la direction Z, elle s'étend selon la direction X et est fine selon la direction Y. La première lame de couplage 120 transmet donc le déplacement selon la direction X grâce à sa forte raideur de compression, tout en faisant cohabiter la translation de la pièce de transmission 8 et la rotation du bras de levier supplémentaire 100 grâce à sa faible raideur en flexion. Sur le même principe, une seconde lame de couplage 130 vient transmettre le mouvement selon X de l'autre extrémité 100B du bras de levier supplémentaire 100 à une électrode mobile 61 maintenue en translation selon X. Le bras de levier supplémentaire permet ainsi de multiplier le déplacement par le rapport entre la distance entre la charnière 110 et la seconde lame de couplage 130 sur la distance entre la charnière 110 et la première lame de couplage 120.

Dans l'ensemble des modes décrits, par « mince », il faut comprendre de l'ordre de la centaine de nanomètres (nm), et inférieur à quelques micromètres (µm) (NEMS) et par « épais », il faut comprendre entre quelques µm et quelques dizaines de µm (MEMS).

De préférence, l'épaisseur d'une couche mince est comprise entre 200 nm et 2 µm

De préférence, l'épaisseur d'une couche épaisse est comprise entre 5 et 30 µm, voire entre 10 et 20 µm.

Sauf indication contraire, les différents modes présentés peuvent être combinés entre eux. En outre, la présente invention n'est pas limitée aux modes de réalisation précédemment décrits mais s'étend à tout mode de réalisation entrant dans la portée des revendications

La liaison mécanique et la structure microélectromécanique et/ou nanoélectromécanique de l'invention peut être fabriquée en utilisant les technologies de micro-usinage (et/ou nano-usinage) d'accéléromètres connues, sur du silicium.

Pour réaliser une telle liaison mécanique et une telle structure microélectromécanique et nanoélectromécanique, on peut mettre en oeuvre le procédé général suivant :
- on part d'un silicium sur isolant (SOI) comprenant au moins une couche de substrat en Si, sur laquelle est disposée une première couche d'oxyde de silicium (SiO2) de quelques centaines de nanomètres à quelques microns servant de première couche sacrificielle lors de la libération des pièces mobiles, et sur la première couche de SiO2 est disposée une couche mince de silicium monocristallin (NEMS) de quelques centaines de nanomètres à quelques microns servant à réaliser les jauges de contraintes ainsi que les lames minces ;
- les motifs de la couche NEMS sont réalisés par photolithographie et gravure pour détourer les jauges de contraintes ainsi que les lames minces ;
- une seconde couche sacrificielle d'oxyde de silicium, elle aussi de quelques centaines de nanomètres à quelques microns, est ensuite déposée. Cette seconde couche de SiO2 est gravée pour ne rester qu'à certains endroits où elle servira de couche d'arrêt lors de la gravure profonde de la couche épaisse (MEMS) lors de l'étape suivante. Ainsi, la couche NEMS peut être protégée. La seconde couche d'oxyde est détruite lors d'étape de la libération finale ;

- ensuite une étape d'épitaxie de silicium est réalisée, qui permet d'obtenir la couche épaisse (MEMS, quelques microns à quelques dizaines de microns). Cette couche est mise en forme par photolithographie et gravure profonde (Deep Reactive Ion Etching) ;
- enfin, les pièces mobiles sont libérées grâce à la gravure partielle des couches sacrificielles d'oxyde de silicium. On peut notamment exposer la plaque à l'acide fluorhydrique, avantageusement en phase vapeur, pendant une durée contrôlée.

La liaison mécanique selon l'invention est donc particulièrement adaptée à la réalisation d'un dispositif de mesure d'une variation de pression, par exemple pour réaliser un microphone ou un capteur de pression. Une membrane ou un piston, en contact avec l'environnement extérieur, capte les variations de pression acoustique et les moyens de détection, avantageusement capacitifs, mesurent ces variations de pression.

Les moyens de détection peuvent comprendre une capacité, une poutre de résonance, ou des moyens piézorésistifs ou piézoélectriques sous forme de jauge de contrainte ou encore une combinaison desdits moyens ... Avantageusement, ils peuvent comprendre au moins deux capacités, deux jauges de contraintes ou deux résonateurs de manière à réaliser une mesure différentielle.

## Revendications

1. Liaison mécanique (1) pour un dispositif microélectromécanique et/ou nanoélectromécanique de mesure d'une variation de pression, ledit dispositif comprenant une pièce fixe (2) s'étendant selon un plan principal (OXY), une pièce mobile (4, 4', 4", 4'") apte à se déplacer ou à se déformer selon une direction hors-plan (Z) sous l'effet d'une variation de pression, et des moyens de détection (6, 6') dudit déplacement ou de ladite déformation comprenant au moins un élément mobile (61, 61'), la liaison mécanique comprenant :
- un bras de levier (10) ;
- une première liaison (3) reliant la pièce mobile (4, 4', 4", 4'") à une première extrémité (10.1) du bras de levier (10), ladite première liaison étant adaptée pour transmettre le déplacement hors plan de ladite pièce mobile à ladite première extrémité du bras de levier tout en permettant la rotation hors-plan dudit bras de levier autour d'une direction de rotation (Y) ;
- une deuxième liaison (5, 5') reliée à la seconde extrémité (10.2) du bras de levier (10) et configurée pour permettre principalement une rotation hors-plan du bras de levier (10) autour d'un axe de rotation (Y5, Y5') s'étendant selon la direction de rotation (Y) ; ladite liaison mécanique étant **caractérisée en ce qu'**elle comprend en outre :
- une troisième liaison (7, 7') connectant le bras de levier (10) aux moyens de détection (6, 6') à une distance donnée (d) par rapport à l'axe de rotation (Y5, Y5') selon la direction hors-plan (Z), ladite troisième liaison étant adaptée pour autoriser une rotation autour d'un axe de flexion (Y7, Y7') qui suit la même direction (Y) que l'axe de rotation (Y5, Y5') mais qui est décalé de la distance (d) selon la direction hors-plan (Z) par rapport audit axe de rotation, de sorte à transformer la rotation du bras de levier (10) selon ledit axe de rotation en une translation dans le plan (OXY) du au moins un élément mobile (61, 61') selon une direction de translation (X).

2. Liaison mécanique (1) selon la revendication 1 **caractérisée en ce que** les moyens de détection (6, 6') comprennent une pièce de transmission (8) connectée à le au moins un élément mobile (61, 61') des moyens de détection, la troisième liaison (7, 7') étant reliée à la pièce de transmission (8) de sorte à transmettre la translation selon la direction de translation (X) audit élément mobile par l'intermédiaire de ladite pièce de transmission.

3. Liaison mécanique (1) selon la revendication 1 ou la revendication 2 **caractérisée en ce qu'**elle comprend en outre une quatrième liaison (9) de type liaison glissière reliée à le au moins un élément mobile (61, 61') ou à la pièce de transmission (8), et configurée pour guider ledit élément mobile ou ladite pièce de transmission en translation selon la direction de translation (X).

4. Liaison mécanique (1) selon la revendication 3 **caractérisée en ce que** la quatrième liaison (9) comprend au moins une simple lame épaisse (91) de flexion dans le plan (OXY), ladite lame étant fine selon la direction de translation (X).

5. Liaison mécanique (1) selon la revendication 3 **caractérisée en ce que** la quatrième liaison (9) comprend au moins une double lame épaisse de flexion dans le plan (OXY), chaque lame étant fine selon la direction de translation (X).

6. Liaison mécanique (1) selon l'une quelconque des revendications précédentes **caractérisée en ce que** la première liaison (3) comprend au moins une lame épaisse (31) de torsion hors-plan autour d'un axe de torsion (Y3) parallèle à la direction de rotation (Y).

7. Liaison mécanique (1) selon l'une quelconque des revendications précédentes **caractérisée en ce que** la deuxième liaison (5, 5') comprend au moins une première lame épaisse (51, 51') de torsion hors-plan autour de la direction de rotation (Y) et/ou au moins une deuxième lame (52, 52') de flexion hors-plan autour de ladite direction de rotation, chacune des première et/ou seconde lames étant reliées d'une part au bras de levier (10) et d'autre part à la pièce fixe (2), par exemple à l'aide d'au moins un plot d'ancrage (25).

8. Liaison mécanique (1) selon l'une quelconque des revendications précédentes **caractérisée en ce que** la troisième liaison (7, 7') comprend une lame (71, 71') de flexion hors plan autour d'un axe de flexion (Y7, Y7'), ladite lame s'étendant selon la direction de translation (X), et étant soit une lame épaisse, soit une lame mince, l'axe de flexion (Y7, Y7') étant parallèle à l'axe de rotation (Y5, Y5') et décalé de la distance donnée (d) par rapport audit axe de rotation selon la direction hors-plan (Z).

9. Dispositif de mesure d'une variation de pression comprenant une pièce fixe (2) s'étendant selon un plan principal (OXY), une pièce mobile (4, 4', 4", 4'") se déplaçant ou se déformant hors-plan sous l'effet d'une variation de pression, des moyens de détection (6, 6') dudit déplacement ou de ladite déformation et une liaison mécanique (1) selon l'une des revendications 1 à 8, ladite liaison mécanique étant configurée pour relier la pièce mobile (4, 4', 4", 4"') à au moins un élément mobile (61, 61') des moyens de détection (6, 6').

10. Dispositif de mesure d'une variation de pression selon la revendication 9 **caractérisé en ce que** la pièce mobile est une membrane (4, 4", 4'") souple ou semi-rigide.

11. Dispositif de mesure d'une variation de pression selon la revendication 9 **caractérisé en ce que** la pièce mobile est un piston (4') rigide.

12. Dispositif de mesure d'une variation de pression selon l'une des revendications 9 à 11 **caractérisé en ce qu'**il comprend une chambre de mesure (60) à pression réduite, une membrane d'étanchéité (14) fermant au moins partiellement ladite chambre de mesure et des moyens de liaison étanche (20) entre l'intérieur et l'extérieur de ladite chambre de mesure, la première liaison (3) étant disposée à l'extérieur de la chambre de mesure, la deuxième liaison (5) étant reliée aux moyens de liaison étanche (20), les moyens de détection (6) et la troisième liaison (7) étant disposés dans la chambre de mesure.

13. Dispositif de mesure d'une variation de pression selon l'une des revendications 9 à 12 **caractérisé en ce que** les moyens de détection (6) comprennent une électrode mobile (61) connectée à la troisième liaison (7) ou à la pièce de transmission (8) et au moins une électrode fixe (62), lesdites électrodes s'étendant dans le plan principal (OXY) et l'entrefer entre l'électrode mobile et la au moins une électrode fixe étant défini par une dimension des électrodes dans le plan principal et par l'épaisseur desdites électrodes, le mouvement de translation transmis par la troisième liaison à l'électrode mobile (61) étant apte à faire varier l'entrefer entre ladite électrode mobile et ladite au moins une électrode fixe selon la direction de translation (X).

14. Dispositif de mesure d'une variation de pression selon la revendication 13 **caractérisé en ce que** les électrodes (61, 62) comprennent plusieurs doigts (610, 620), les doigts (610) de l'électrode mobile (61) étant interdigités avec les doigts (620) de la au moins une électrode fixe (62) et **en ce que** les doigts (610, 620) des électrodes (61, 62) s'étendent perpendiculairement à la direction (X) de la translation transmise à l'électrode mobile (61).

15. Dispositif de mesure d'une variation de pression selon l'une des revendications 9 à 12 **caractérisé en ce que** les moyens de détection (6') comprennent une électrode mobile (61') connectée à la troisième liaison (7) ou à la pièce de transmission (8) et au moins une électrode fixe (62'), lesdites électrodes s'étendant dans le plan principal (OXY) et les surfaces en regard entre l'électrode mobile et la au moins une électrode fixe étant définies par une dimension des électrodes dans le plan principal et par l'épaisseur desdites électrodes, le mouvement de translation transmis par la troisième liaison à l'électrode mobile étant apte à faire varier les surfaces en regard entre ladite électrode mobile et ladite au moins une électrode fixe selon la direction de translation (X).

16. Dispositif de mesure d'une variation de pression selon la revendication 15 **caractérisé en ce que** les électrodes (61', 62') comprennent plusieurs doigts (610', 620'), les doigts (610') de l'électrode mobile (61') étant interdigités avec les doigts (620') de la au moins une électrode fixe (62') et **en ce que** les doigts des électrodes (61', 62') s'étendent dans la direction (X) de la translation transmise à l'électrode mobile (61').

17. Dispositif de mesure d'une variation de pression selon l'une des revendications 12 à 16 caractérisé en ce les moyens de détection comprennent deux électrodes fixes (62, 62', 63, 63') de manière à réaliser une détection différentielle.

18. Dispositif de mesure d'une variation de pression selon l'une des revendications 9 à 12, les moyens de détection comprenant une poutre de résonance, des moyens d'excitation latérale à ladite poutre et des moyens de mesure de la déformation de ladite poutre selon ladite direction latérale, par exemple des jauges piézorésistives de part et d'autre de la poutre résonante.

19. Dispositif de mesure d'une variation de pression selon l'une des revendications 9 à 18 **caractérisé en ce qu'**il comprend au moins deux liaisons mécaniques (1) selon l'une des revendications 1 à 8.

## Patentansprüche

1. Mechanische Verbindung (1) für eine mikroelektromechanische und/oder nanoelektromechanische Vorrichtung zum Messen einer Druckveränderung, wobei die Vorrichtung ein feststehendes Teil (2), das sich entlang einer Hauptebene (OXY) erstreckt, ein bewegliches Teil (4, 4', 4", 4‴), das sich unter Einwirkung einer Druckveränderung entlang einer Richtung außerhalb der Ebene (Z) verschieben oder verformen kann, und Mittel (6, 6') zum Erkennen der Verschiebung oder der Verformung, umfassend mindestens ein bewegliches Element (61, 61'), umfasst, wobei die mechanische Verbindung Folgendes umfasst:
- einen Hebelarm (10);
- eine erste Verbindung (3), die das bewegliche Teil (4, 4', 4", 4‴) mit einem ersten Ende (10.1) des Hebelarms (10) verbindet, wobei die erste Verbindung dafür geeignet ist, die Verschiebung des beweglichen Teils außerhalb der Ebene auf das erste Ende des Hebelarms zu übertragen und dabei die Drehung des Hebelarms außerhalb der Ebene um eine Drehrichtung (Y) zuzulassen;
- eine zweite Verbindung (5, 5'), die mit dem zweiten Ende (10.2) des Hebelarms (10) verbunden und dafür konfiguriert ist, in erster Linie eine Drehung des Hebelarms (10) außerhalb der Ebene um eine Drehachse (Y5, Y5') zuzulassen, die sich entlang der Drehrichtung (Y) erstreckt; wobei die mechanische Verbindung **dadurch gekennzeichnet ist, dass** sie ferner Folgendes umfasst:
- eine dritte Verbindung (7, 7'), die den Hebelarm (10) in einem gegebenen Abstand (d) in Bezug auf die Drehachse (Y5, Y5') entlang der Richtung außerhalb der Ebene (Z) mit den Erkennungsmitteln (6, 6') verbindet, wobei die dritte Verbindung dafür geeignet ist, eine Drehung um eine Biegeachse (Y7, Y7') zu ermöglichen, die der gleichen Richtung (Y) folgt wie die Drehachse (Y5, Y5'), die jedoch um den Abstand (d) entlang der Richtung außerhalb der Ebene (Z) in Bezug auf die Drehachse versetzt ist, so dass die Drehung des Hebelarms (10) entlang der Drehachse in eine Translation in der Ebene (OXY) des mindestens einen beweglichen Elements (61, 61') entlang einer Translationsrichtung (X) umgewandelt wird.

2. Mechanische Verbindung (1) nach Anspruch 1, **dadurch gekennzeichnet, dass** die Erkennungsmittel (6, 6') ein Übertragungsteil (8) umfassen, das mit dem mindestens einen beweglichen Element (61, 61') der Erkennungsmittel verbunden ist, wobei die dritte Verbindung (7, 7') derart mit dem Übertragungsteil (8) verbunden ist, dass die Translation entlang der Translationsrichtung (X) mittels des Übertragungsteils auf das bewegliche Element übertragen wird.

3. Mechanische Verbindung (1) nach Anspruch 1 oder Anspruch 2, **dadurch gekennzeichnet, dass** sie ferner eine vierte Verbindung (9) vom Gleitverbindungstyp umfasst, die mit dem mindestens einen beweglichen Element (61, 61') oder dem Übertragungsteil (8) verbunden und dafür konfiguriert ist, das bewegliche Element oder das Übertragungsteil in Translation entlang der Translationsrichtung (X) zu führen.

4. Mechanische Verbindung (1) nach Anspruch 3, **dadurch gekennzeichnet, dass** die vierte Verbindung (9) mindestens eine einfache dicke Biegelamelle (91) zum Biegen in der Ebene (OXY) umfasst, wobei die Lamelle entlang der Translationsrichtung (X) schmal ist.

5. Mechanische Verbindung (1) nach Anspruch 3, **dadurch gekennzeichnet, dass** die vierte Verbindung (9) mindestens eine doppelte dicke Biegelamelle zum Biegen in der Ebene (OXY) umfasst, wobei jede Lamelle entlang der Translationsrichtung (X) schmal ist.

6. Mechanische Verbindung (1) nach einem der vorhergehenden Ansprüche, **dadurch gekennzeichnet, dass** die erste Verbindung (3) mindestens eine dicke Verwindungslamelle (31) zum Verwinden außerhalb der Ebene um eine Verwindungsachse (Y3) parallel zur Drehrichtung (Y) umfasst.

7. Mechanische Verbindung (1) nach einem der vorhergehenden Ansprüche, **dadurch gekennzeichnet, dass** die zweite Verbindung (5, 5') mindestens eine erste dicke Verwindungslamelle (51, 51') zum Verwinden außerhalb der Ebene um die Drehrichtung (Y) und/oder mindestens eine zweite Biegelamelle (52, 52') zum Biegen außerhalb der Ebene um die Drehrichtung umfasst, wobei jede von der ersten und/oder der zweiten Lamelle einerseits mit dem Hebelarm (10) und andererseits mit dem feststehenden Teil (2), zum Beispiel mittels mindestens eines Verankerungsblocks (25), verbunden ist.

8. Mechanische Verbindung (1) nach einem der vorhergehenden Ansprüche, **dadurch gekennzeichnet, dass** die dritte Verbindung (7, 7') eine Biegelamelle (71, 71') zum Biegen außerhalb der Ebene um eine Biegeachse (Y7, Y7') umfasst, wobei sich die Lamelle entlang der Translationsrichtung (X) erstreckt und entweder eine dicke Lamelle oder eine dünne Lamelle ist, wobei die Biegeachse (Y7, Y7') parallel zur Drehachse (Y5, Y5') und um den gegebenen Abstand (d) in Bezug auf die Drehachse entlang der Richtung außerhalb der Ebene (Z) versetzt ist.

9. Vorrichtung zum Messen einer Druckveränderung, umfassend ein feststehendes Teil (2), das sich entlang einer Hauptebene (OXY) erstreckt, ein bewegliches Teil (4, 4', 4", 4‴), das sich unter Einwirkung einer Druckveränderung außerhalb der Ebene verschiebt oder verformt, Mittel (6, 6') zum Erkennen der Verschiebung oder Verformung und eine mechanische Verbindung (1) nach einem der Ansprüche 1 bis 8, wobei die mechanische Verbindung dafür konfiguriert ist, das bewegliche Teil (4, 4', 4", 4‴) mit mindestens einem beweglichen Element (61, 61') der Erkennungsmittel (6, 6') zu verbinden.

10. Vorrichtung zum Messen einer Druckveränderung nach Anspruch 9, **dadurch gekennzeichnet, dass** das bewegliche Teil eine flexible oder halbstarre Membran (4, 4", 4‴) ist.

11. Vorrichtung zum Messen einer Druckveränderung nach Anspruch 9, **dadurch gekennzeichnet, dass** das bewegliche Teil ein starrer Kolben (4') ist.

12. Vorrichtung zum Messen einer Druckveränderung nach einem der Ansprüche 9 bis 11, **dadurch gekennzeichnet, dass** sie eine Messkammer (60) mit verringertem Druck, eine Dichtungsmembran (14), die die Messkammer mindestens teilweise abschließt, und dichte Verbindungsmittel (20) zwischen dem Inneren und dem Äußeren der Messkammer umfasst, wobei die erste Verbindung (3) außerhalb der Messkammer angeordnet ist, die zweite Verbindung (5) mit den dichten Verbindungsmitteln (20) verbunden ist, die Erkennungsmittel (6) und die dritte Verbindung (7) in der Messkammer angeordnet sind.

13. Vorrichtung zum Messen einer Druckveränderung nach einem der Ansprüche 9 bis 12, **dadurch gekennzeichnet, dass** die Erkennungsmittel (6) eine bewegliche Elektrode (61), die mit der dritten Verbindung (7) oder mit dem Übertragungsteil (8) verbunden ist, und mindestens eine feststehende Elektrode (62) umfassen, wobei sich die Elektroden in der Hauptebene (OXY) erstrecken und der Luftspalt zwischen der beweglichen Elektrode und der mindestens einen feststehenden Elektrode durch eine Abmessung der Elektroden in der Hauptebene und durch die Dicke der Elektroden definiert ist, wobei die Translationsbewegung, die durch die dritte Verbindung auf die bewegliche Elektrode (61) übertragen wird, den Luftspalt zwischen der beweglichen Elektrode und der mindestens einen feststehenden Elektrode entlang der Translationsrichtung (X) variieren kann.

14. Vorrichtung zum Messen einer Druckveränderung nach Anspruch 13, **dadurch gekennzeichnet, dass** die Elektroden (61, 62) mehrere Finger (610, 620) umfassen, wobei die Finger (610) der beweglichen Elektrode (61) mit den Fingern (620) der mindestens einen feststehenden Elektrode (62) ineinandergreifen, und dass sich die Finger (610, 620) der Elektroden (61, 62) senkrecht zu der Richtung (X) der auf die bewegliche Elektrode (61) übertragenen Translation erstrecken.

15. Vorrichtung zum Messen einer Druckveränderung nach einem der Ansprüche 9 bis 12, **dadurch gekennzeichnet, dass** die Erkennungsmittel (6') eine bewegliche Elektrode (61'), die mit der dritten Verbindung (7) oder mit dem Übertragungsteil (8) verbunden sind, und mindestens eine feststehende Elektrode (62') umfassen, wobei sich die Elektroden in der Hauptebene (OXY) erstrecken und die einander gegenüberliegenden Oberflächen der beweglichen Elektrode und der mindestens einen feststehenden Elektrode durch eine Abmessung der Elektroden in der Hauptebene und durch die Dicke der Elektroden definiert ist, wobei die Translationsbewegung, die durch die dritte Verbindung auf die bewegliche Elektrode übertragen wird, in der Lage ist, die einander gegenüberliegenden Oberflächen der beweglichen Elektrode und der mindestens einen feststehenden Elektrode entlang der Translationsrichtung (X) zu verändern.

16. Vorrichtung zum Messen einer Druckveränderung nach Anspruch 15, **dadurch gekennzeichnet, dass** die Elektroden (61', 62') mehrere Finger (610', 620') umfassen, wobei die Finger (610') der beweglichen Elektrode (61') mit den Fingern (620') der mindestens einen feststehenden Elektrode (62') ineinandergreifen, und dass sich die Finger der Elektroden (61', 62') in der Richtung (X) der auf die bewegliche Elektrode (61') übertragenen Translation erstrecken.

17. Vorrichtung zum Messen einer Druckveränderung nach einem der Ansprüche 12 bis 16, **dadurch gekennzeichnet, dass** die Erkennungsmittel zwei feststehende Elektroden (62, 62', 63, 63') umfassen, so dass eine differentielle Erkennung ausgeführt wird.

18. Vorrichtung zum Messen einer Druckveränderung nach einem der Ansprüche 9 bis 12, wobei die Erkennungsmittel einen Resonanzträger, zu dem Träger laterale Erregungsmittel und Mittel zum Messen der Verformung des Trägers entlang der lateralen Richtung, zum Beispiel piezoresistive Messwerkzeuge auf beiden Seiten des Resonanzträgers, umfassen.

19. Vorrichtung zum Messen einer Druckveränderung nach einem der Ansprüche 9 bis 18, **dadurch gekennzeichnet, dass** sie mindestens zwei mechanische Verbindungen (1) nach einem der Ansprüche 1 bis 8 umfasst.

## Claims

1. A mechanical connection (1) for a microelectromechanical and/or nanoelectromechanical device for measuring a variation in pressure, said device comprising a fixed component (2) extending in a main plane (OXY), a mobile component (4, 4', 4", 4"') able to move or to deform in an out-of-plane direction (Z) under the effect of a variation in pressure, and detection means (6, 6') for detecting said movement or said deformation comprising at least one mobile element (61, 61'), the mechanical connection comprising:
- a lever arm (10);
- a first connection (3) connecting the mobile component (4, 4', 4", 4‴) to a first end (10.1) of the lever arm (10), said first connection being adapted to transmit the out-of-plane movement of said mobile component to said first end of the lever arm while allowing the out-of-plane rotation of said lever arm about a direction of rotation (Y);
- a second connection (5, 5') connected to the second end (10.2) of the lever arm (10) and configured to allow mainly an out-of-plane rotation of the lever arm (10) about an axis of rotation (Y5, Y5') extending in the direction of rotation (Y); said mechanical connection being **characterised in that** it further comprises:
- a third connection (7, 7') connecting the lever arm (10) to the detection means (6, 6') at a given distance (d) from the axis of rotation (Y5, Y5') in the out-of-plane direction (Z), said third connection being adapted to allow rotation about an axis of bending (Y7, Y7') which follows the same direction (Y) as the axis of rotation (Y5, Y5'), but which is offset by the distance (d) in the out-of-plane direction (Z) from said axis of rotation, so as to convert the rotation of the lever arm (10) about said axis of rotation into a translation in the plane (OXY) of the at least one mobile element (61, 61') in a direction of translation (X).

2. A mechanical connection (1) according to claim 1, **characterised in that** the detection means (6, 6') comprise a transmission component (8) connected to the at least one mobile element (61, 61') of the detection means, the third connection (7, 7') being connected to the transmission component (8) so as to transmit the translation in the direction of translation (X) to said mobile element via said transmission component.

3. A mechanical connection (1) according to claim 1 or claim 2, **characterised in that** it further comprises a fourth connection (9) of the sliding-connection type, connected to the at least one mobile element (61, 61') or to the transmission component (8) and configured to guide said mobile element or said transmission component in translation in the direction of translation (X).

4. A mechanical connection (1) according to claim 3, **characterised in that** the fourth connection (9) comprises at least a simple thick bending blade (91) bending in the plane (OXY), said blade being slender in the direction of translation (X).

5. A mechanical connection (1) according to claim 3, **characterised in that** the fourth connection (9) comprises at least a double thick bending blade, bending in the plane (OXY), each blade being slender in the direction of translation (X).

6. A mechanical connection (1) according to any one of the preceding claims, **characterised in that** the first connection (3) comprises at least one thick torsion blade (31) twisting out-of-plane about a torsion axis (Y3) parallel to the direction of rotation (Y).

7. A mechanical connection (1) according to any one of the preceding claims, **characterised in that** the second connection (5, 5') comprises at least a first thick torsion blade (51, 51') twisting out-of-plane about the direction of rotation (Y) and/or at least a second bending blade (52, 52') bending out-of-plane about said direction of rotation, each of the first and/or second blades being connected on the one hand to the lever arm (10) and on the other hand to the fixed component (2), for example using at least one anchoring block (25).

8. A mechanical connection (1) according to any one of the preceding claims, **characterised in that** the third connection (7, 7') comprises a bending blade (71, 71') bending out-of-plane about a bending axis (Y7, Y7'), said blade extending in the direction of translation (X) and being either a thick blade or a thin blade, the bending axis (Y7, Y7') being parallel to the axis of rotation (Y5, Y5') and offset by the given distance (d) with respect to said axis of rotation in the out-of-plane direction (Z).

9. A device for measuring a variation in pressure comprising a fixed component (2) extending in a main plane (OXY), a mobile component (4, 4', 4", 4‴) moving or deforming out-of-plane under the effect of a variation in pressure, detection means (6, 6') for detecting said movement or said deformation and a mechanical connection (1) according to one of claims 1 to 8, said mechanical connection being configured to connect the mobile component (4, 4', 4", 4‴) to at least one mobile element (61, 61') of the detection means (6, 6').

10. The device for measuring a variation in pressure according to claim 9, **characterised in that** the mobile component is a flexible or semi-rigid membrane (4, 4", 4‴).

11. The device for measuring a variation in pressure according to claim 9, **characterised in that** the mobile component is a rigid piston (4').

12. The device for measuring a variation in pressure according to one of claims 9 to 11, **characterised in that** it comprises a reduced-pressure measurement chamber (60), a sealing membrane (14) at least partially closing said measurement chamber and means (20) of fluidtight connection between the inside and the outside of said measurement chamber, the first connection (3) being positioned outside of the measurement chamber, the second connection (5) being connected to the fluidtight-connection means (20), the detection means (6) and the third connection (7) being positioned in the measurement chamber.

13. The device for measuring a variation in pressure according to one of claims 9 to 12, **characterised in that** the detection means (6) comprise a mobile electrode (61) connected to the third connection (7) or to the transmission component (8) and at least one fixed electrode (62), said electrodes extending in the main plane (OXY) and the airgap between the mobile electrode and the at least one fixed electrode being defined by a dimension of the electrodes in the main plane and by the thickness of said electrodes, the translational motion transmitted by the third connection to the mobile electrode (61) being able to cause the airgap between said mobile electrode and said at least one fixed electrode to vary in the direction of translation (X).

14. The device for measuring a variation in pressure according to claim 13, **characterised in that** the electrodes (61, 62) comprise multiple fingers (610, 620), the fingers (610) of the mobile electrode (61) being interdigitated with the fingers (620) of the at least one fixed electrode (62) and **in that** the fingers (610, 620) of the electrodes (61, 62) extend perpendicular to the direction (X) of the translation transmitted to the mobile electrode (61).

15. The device for measuring a variation in pressure according to one of claims 9 to 12, **characterised in that** the detection means (6') comprise a mobile electrode (61') connected to the third connection (7) or to the transmission component (8) and at least one fixed electrode (62'), said electrodes extending in the main plane (OXY) and the mutually-facing surface areas between the mobile electrode and the at least one fixed electrode being defined by a dimension of the electrodes in the main plane and by the thickness of said electrodes, the translational motion transmitted by the third connection to the mobile electrode being able to cause the mutually-facing surface areas between said mobile electrode and said at least one fixed electrode to vary in the direction of translation (X).

16. The device for measuring a variation in pressure according to claim 15, **characterised in that** the electrodes (61', 62') comprise multiple fingers (610', 620'), the fingers (610') of the mobile electrode (61') being interdigitated with the fingers (620') of the at least one fixed electrode (62') and **in that** the fingers of the electrodes (61', 62') extend in the direction (X) of the translation transmitted to the mobile electrode (61').

17. The device for measuring a variation in pressure according to one of claims 12 to 16, **characterised in that** the detection means comprise two fixed electrodes (62, 62', 63, 63') so as to perform differential detection.

18. The device for measuring a variation in pressure according to one of claims 9 to 12, the detection means comprising a resonant beam, excitation means lateral to said beam and means for measuring the deformation of said beam in said lateral direction, for example piezoresistive gauges on either side of the resonant beam.

19. The device for measuring a variation in pressure according to one of claims 9 to 18, **characterised in that** it comprises at least two mechanical connections (1) according to one of claims 1 to 8.
